# EUROPÄISCHE PATENTSCHRIFT

(11) **EP 2 954 440 B1**
(45) Veröffentlichungstag und Bekanntmachung des Hinweises auf die Patenterteilung: **12.01.2022**
(21) Anmeldenummer: 14703849.1
(22) Anmeldetag: 11.02.2014
(51) Int. Cl.: G06F 30/331

(54) **VERÄNDERN EINES SIGNALWERTS EINES FPGA ZUR LAUFZEIT**
ALTERATION OF A SIGNAL VALUE FOR AN FPGA AT RUNTIME
MODIFICATION D'UNE VALEUR DE SIGNAL D'UN FPGA AU COURS DU FONCTIONNEMENT

(30) Priorität: 11.02.2013 DE 102013101300; 11.02.2013 EP 13154741
(43) Veröffentlichungstag der Anmeldung: 16.12.2015
(73) Patentinhaber: dSPACE digital signal processing and control engineering GmbH, 33102 Paderborn (DE)
(72) Erfinder: KALTE, Heiko, Dr., 33106 Paderborn (DE); FUNKE, Lukas, 33102 Paderborn (DE)
(86) Internationale Anmeldenummer: PCT/EP2014/052625
(87) Internationale Veröffentlichungsnummer: WO 2014/122320

(56) Entgegenhaltungen:
- M. A. Aguirre ET AL: "UNSHADES-1: An Advanced Tool for In-System Run-Time Hardware Debugging" In: "Field Programmable Logic and Application", 1. Januar 2003 (2003-01-01), Springer Berlin Heidelberg, Berlin, Heidelberg, XP055067816, ISSN: 0302-9743 ISBN: 978-3-54-045234-8 Bd. 2778, Seiten 1170-1173, DOI: 10.1007/978-3-540-45234-8_146, Seite 1172 - Seite 1175
- J. Tombs ET AL: "The Implementation of a FPGA Hardware Debugger System with Minimal System Overhead" In: "Field Programmable Logic and Application", 1. Januar 2004 (2004-01-01), Springer Berlin Heidelberg, Berlin, Heidelberg, XP055067915, ISSN: 0302-9743 ISBN: 978-3-54-045234-8 Bd. 3203, Seiten 1062-1066, DOI: 10.1007/978-3-540-30117-2_127, Seite 1063
- AGUIRRE M A ET AL: "Improving the design process of VLSI circuits by means of a hardware debugging system: UNSHADES-1 framework", IECON-2002. PROCEEDINGS OF THE 28TH. ANNUAL CONFERENCE OF THE IEEE INDUSTRIAL ELECTRONICS SOCIETY. SEVILLA, SPAIN, NOV. 5 - 8, 2002; [ANNUAL CONFERENCE OF THE IEEE INDUSTRIAL ELECTRONICS SOCIETY], IEEE, NEW YORK,NY, US, Bd. 3, 5. November 2002 (2002-11-05), Seiten 2544-2547, XP010633112, DOI: 10.1109/IECON.2002.1185374 ISBN: 978-0-7803-7474-4
- "Virtex Series Configuration Architecture User Guide. XAPP151 (v.17)", Application Note: Virtex Series, 1. Oktober 2004 (2004-10-01), Seiten 1-45, XP055133863, Gefunden im Internet: URL:http://www.xilinx.com/support/document ation/application_notes/xapp151.pdf [gefunden am 2014-08-07]
- "Virtex FPGA Series Configuration and Readback. XAPP138 (v2.8)", Application Note:Virtex Series, 1. März 2005 (2005-03-01), Seiten 1-37, XP055067819, Gefunden im Internet: URL:http://www.xilinx.com/support/document ation/application_notes/xapp138.pdf [gefunden am 2013-06-21]
- None
- Paul Graham ET AL: "Improving the FPGA Design Process Through Determining and Applying Logical-to-Physical Design Mappings", , 1 January 2000 (2000-01-01), pages 1-12, XP055067891, Provo,UT,84602 DOI: 10.1109/FPGA.2000.903429 Retrieved from the Internet: URL:http://www.dtic.mil/cgi-bin/GetTRDoc?A D=ADA451583 [retrieved on 2013-06-21]

## Beschreibung

Die vorliegende Erfindung betrifft ein Verfahren zum Verändern eines Signalwerts eines FPGA zur Laufzeit. Ebenfalls betrifft die Erfindung eine Datenverarbeitungseinrichtung mit einer Prozessoreinheit und einem FPGA, wobei die Datenverarbeitungseinrichtung zur Durchführung des obigen Verfahrens ausgeführt ist. Auch betrifft die Erfindung ein Computerprogrammprodukt mit Computer-implementierten Anweisungen, das nach dem Laden und Ausführen in einer geeigneten Datenverarbeitungseinrichtung die Schritte des obigen Verfahrens ausführt sowie ein digitales Speichermedium mit elektronisch auslesbaren Steuersignalen, die so mit einer programmierbaren Datenverarbeitungseinrichtung zusammenwirken können, dass das obige Verfahren ausgeführt wird.

Aus dem Aufsatz "UNSHADES-1: An Advanced Tool for In-System Run-Time Hardware Debugging" ist ein Verfahren bekannt, bei dem Registerwerte eines FPGA im angehaltenen Zustand verändert werden.

Die Echtzeitsimulation von komplexen, dynamischen Modellen stellt aufgrund der engen zeitlichen Randbedingungen selbst an moderne Rechenknoten hohe Anforderungen. In automotiven Hardware-in-the-Loop-Simulationen (HiL) werden solche Modelle vor allem dort eingesetzt, wo schnelle Regelkreise geschlossen werden müssen, z.B. für sehr dynamische Teile des Umgebungsmodells. Dies ist etwa bei der Simulation von Zylinderinnendrucksensoren der Fall, die bei der Verbrauchs- oder Abgasreduktion eine zunehmend größere Rolle spielen. Aber auch bei Regelstrecken die eine hohe Dynamik aufweisen, wie zum Beispiel bei Elektromotoren, sind kurze Zykluszeiten und geringe Latenzen unabdingbar.

Diese können mit CPU-basierten Simulationen praktisch kaum mehr umgesetzt werden. Auch im Bereich von Rapid Control Prototyping (RCP) halten FPGAs immer mehr Einzug, da die simulierten Umgebungsmodelle (z.B. simulierter Elektromotor) oder die Steuergeräte immer genauer und komplexer werden müssen. In diesem Zusammenhang werden beispielsweise komplexe Reglerteile in ein FPGA ausgelagert, so dass ausreichend präzise und schnelle Reaktionszeiten gewährleistet bleiben.

Field Programmable Gate Arrays (FPGAs) können Rechenknoten bei der Echtzeitsimulation unterstützen, indem sie die Berechnung von dynamischen Teilen eines Modells übernehmen. Durch die hohe Flexibilität und Möglichkeit der Parallelverarbeitung von Signalen lassen sich durch den Einsatz von FPGAs auch harte Echtzeitanforderungen leicht erfüllen. Die FPGAs können als Hardwarebeschleuniger für CPUs von Rechenknoten dienen. Eine solche Erweiterung für einen HiL-Simulator stellt beispielsweise das DS5203-FPGA Board von dSPACE dar. Entsprechend werden z.B. sehr dynamische Teile des Umgebungsmodells in das FPGA ausgelagert, so dass ausreichend präzise und schnelle Reaktionszeiten für das Steuergerät gewährleistet bleiben. Eine FPGA Hardware-Konfiguration wird üblicherweise basierend auf einem FPGA Modell in einer Hardwarebeschreibungssprache in einem Build-Prozess erzeugt.

Die Modelle einer Regelstrecke werden durch steigende Anforderungen an die Genauigkeit zunehmend komplexer und somit auch schwer handhabbar. Im automotiven Hil-Umfeld werden solche Modelle in der Regel mit dem Toolset Matlab/Simulink von The MathWorks Inc. erstellt. Simulink bietet eine blockbasierte Sicht in der Form eines Blockschaltbilds auf solche Modelle. Modellteile können in einem Blockschaltbild zu Subsystemen zusammengefasst und untereinander mit Signalen verknüpft werden. Der Datenfluss zwischen diesen Blöcken wird dabei über Signalleitungen dargestellt.

In einer CPU-basierenden Echtzeitsimulation wird das Blockschaltbild eines Modells mit Hilfe des Simulink Coders zunächst in C/C++ Quelldateien übersetzt. Diese werden anschließend über einen Compiler in eine ausführbare Applikation übersetzt, die auf einem Rechenknoten mit einem echtzeitfähigen Betriebssystem ausgeführt werden kann. Zusätzlich wird bei dem CPU-Build ein Trace-File erzeugt, welches ein Topologie File mit seiner grafischen Modellierung, beispielsweise in Simulink, darstellt. Im TRC-File beinhaltet alle zugreifbaren Variablen und bildet die Variablen auf Speicherstellen ab. Die Variablen sind vorzugsweise in einer Topologie ähnlich der des Modells abgelegt.

Die Übersetzung eines Modells in eine CPU-Applikation hat zur Folge, dass die Berechnungen der Simulation sequenziell, in einer festen Schrittweite ausgeführt werden. Ein konsistentes Abbild aller Modellzustände oder Modell-Variablen, wie beispielsweise Daten auf den Signalleitungen oder Ein/Ausgabewerte der Blöcke, ist damit stets im Hauptspeicher des Rechenknoten vorhanden. Durch den direkten Zugang zum Hauptspeicher können die Modell-Variablen in einem Experimentiertool wie bspw. ControlDesk analysiert und/oder manipuliert werden. Ein wahlfreier Schreib-/Lese-Zugriff auf Variablen der HiL-Simulation ist möglich. Anhand des Trace Files können Signalwerte wie z.B. Motor-Drehzahl ausgewählt und durch eine Anzeige ausgeben oder manipuliert werden. Im HiL-Umfeld fasst man diese Vorgehensweise unter den Begriffen "Messen" und "Verstellen" zusammen.

Eine FPGA-basierte Simulation kann unter Zuhilfenahme des Xilinx System Generator (XSG) und des FPGA-Programming Blocksets von dSPACE, analog zur CPU-basierten Simulation, in einem Blockschaltbild mit Simulink modelliert werden.

Im Gegensatz zur CPU-Simulation wird dieses Modell allerdings nicht in eine iterative Programmiersprache übersetzt, sondern in eine Hardwarebeschreibungssprache, die eine kundenspezifische digitale Schaltung beschreibt. Die Beschreibung der kundenspezifischen Schaltung wird durch einen Syntheseprozess in einen FPGA-Konfigurationsdatenstrom übersetzt. Insbesondere im Bereich der Kalibrierung von Steuergeräten, bei der sehr viele Parameter eingestellt werden müssen, ist ein ressourcen-und zeitsparendes Verfahren notwendig. Kalibrierdaten sind üblicherweise als Konstante implementiert, so dass eine Veränderung zur Laufzeit des FPGA üblicherweise nicht gegeben ist.

Für einige FPGAs ist es möglich, zu Debug-Zwecken den kompletten Zustand des FPGA einzufrieren und auszulesen. Durch das geschlossene Ein-/Ausgabeverhalten des FPGAs ist es jedoch nicht möglich, analog zum Hauptspeicher eines Rechenknotens beliebig auf Modellzustände zuzugreifen und diese ggf. zu verändern. Jede Modell-Variable, die der Anwender messen oder verstellen möchte, muss durch explizite Modellierung über Signalleitungen an die Schnittstellen des FPGAs geführt werden. Im Anschluss an diese Anpassung muss das Modell neu übersetzt werden, was mehrere Stunden dauern kann. Dieser Umstand kann zu sehr langen Entwicklungszyklen von FPGA-basierten Echtzeitsimulationen führen. Insbesondere im Bereich der Kalibrierung, z.B. von Steuergeräten, kann dies sehr viele Ressourcen beanspruchen, wenn sehr viele Parameter eingestellt werden müssen.

Ausgehend von dem oben genannten Stand der Technik liegt der Erfindung somit die Aufgabe zugrunde, ein Verfahren, eine Datenverarbeitungseinrichtung, ein Computerprogrammprodukt sowie ein digitales Speichermedium mit elektronisch auslesbaren Steuersignalen der oben genannten Art anzugeben, welche eine Veränderung von Modell-Variablen im FPGA zur Laufzeit und eine Verkürzung von iterativen Entwicklungszyklen bei der Erstellung von FPGA-basierten Echtzeitsimulationen ermöglichen.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Erfindungsgemäß ist somit ein Verfahren zum Verändern eines Signalwerts eines FPGA zur Laufzeit in Anspruch 1 angegeben.

Erfindungsgemäß ist ferner eine Datenverarbeitungseinrichtung mit einer Prozessoreinheit und einem FPGA angegeben, wobei die Datenverarbeitungseinrichtung zur Durchführung des obigen Verfahrens ausgeführt ist.

Erfindungsgemäß ist auch ein Computerprogrammprodukt mit Computer-implementierten Anweisungen, das nach dem Laden und Ausführen in einer geeigneten Datenverarbeitungseinrichtung die Schritte des obigen Verfahrens ausführt, angegeben.

Weiterhin ist erfindungsgemäß ein digitales Speichermedium mit elektronisch auslesbaren Steuersignalen angegeben, die so mit einer programmierbaren Datenverarbeitungseinrichtung zusammenwirken können, dass das obige Verfahren auf der Datenverarbeitungseinrichtung ausgeführt wird.

Grundidee der vorliegenden Erfindung ist es also, das Verändern eines Signalwerts des FPGA zur Laufzeit zu ermöglichen, indem während des Betriebs des FPGA Zustandsdaten in die funktionale Ebene des FPGA geschrieben werden, um einen Signalwert zu verändern. Die Zustandsdaten werden nach Bedarf verändert, um daraus eine Veränderung des Signalwerts in dem FPGA zu bewirken, wobei strukturelle Änderungen an dem FPGA nicht erforderlich sind. Auch eine Unterbrechung des Betriebs des FPGA ist nicht erforderlich. Somit kann auf Signalwerte des FPGA wahlfrei zur Veränderung zugegriffen werden. Die Veränderung der Signalwerte kann wie von der Ausführung einer Software auf einer CPU bekannt erfolgen, inklusive des Zugriffs über Topologie Files (Trace File) und einer grafischen Modellierung mit Simulink. Signalwerte wie z.B. ein Zündzeitpunkt können entsprechend ausgewählt und angezeigt und/oder verändert werden.

Das Verändern eines Signalwerts des FPGA erfordert lediglich, dass ein Wert für den Signalwert auf das FPGA geschrieben wird. Es ist nicht erforderlich, dass der geschrieben Wert von einem zuvor gesetzten Wert des Signalwerts verschieden ist. Da in der Praxis üblicherweise der Wert des Signalwerts geändert wird, wurde hier der Begriff des Veränderns gewählt.

Ebenfalls kann ein Zugriff auf den Signalwert des FPGA ermöglicht werden, indem während des Betriebs des FPGA Zustandsdaten aus dem FPGA ausgelesen und der Signalwert daraus bestimmt wird. Die Zustandsdaten werden ausgelesen und nach Bedarf kombiniert, wobei strukturelle Änderungen an dem FPGA nicht erforderlich sind. Auch eine Unterbrechung des Betriebs des FPGA ist nicht erforderlich. Somit kann auf Signalwerte des FPGA wahlfrei zugegriffen werden. Der Zugriff auf die Signalwerte kann wie von der Ausführung einer Software bekannt erfolgen, inklusive des Zugriffs über Topologie Files (Trace File) und einer grafischen Modellierung mit Simulink. Signalwerte wie z.B. eine Motor-Drehzahl können entsprechend ausgewählt und angezeigt bzw. manipuliert werden.

Außerdem ist ein Verfahren zum Zugriff auf einen Signalwert eines FPGA zur Laufzeit angegeben, umfassend die Schritte Laden einer FPGA Hardware-Konfiguration auf den FPGA, Ausführen der FPGA Hardware-Konfiguration auf dem FPGA, Anfordern eines Signalwertes des FPGA, Übertragen von Zustandsdaten aus einer funktionalen Ebene des FPGA in einen Konfigurationsspeicher in dessen Konfigurationsebene, Auslesen der Zustandsdaten aus dem Konfigurationsspeicher als Rücklesedaten, und Bestimmen des Signalwertes aus den Rücklesedaten. Die einzelnen Schritte korrespondieren mit den zuvor beschriebenen Schritten des Verfahrens zum Verändern eines Signalwerts.

Vorteilhafterweise sind für die Implementierung des FPGA keine Änderungen erforderlich, sodass der Bedarf an Ressourcen und Performance des FPGA unverändert ist. Entsprechend hat der Zugriff auf den Signalwert kein Einfluss auf den normalen Betrieb, weder in Hinsicht auf die erzeugte FPGA Hardware-Konfiguration noch während der Ausführung. Zustände verschiedener Modellvariablen können konsistent gespeichert werden, um einen Zugriff zu ermöglichen. Ein Zugriff auf gewünschte Signalwerte kann erfolgen, ohne dass eine angepasste FPGA Hardware-Konfiguration erzeugt und in das FPGA übertragen werden muss, wodurch Entwicklungszeiten verkürzt werden können. Einfluss auf verfügbaren Ressourcen und das Echtzeitverhalten des FPGA werden vermieden oder reduziert. Insbesondere können ohne Veränderung der FPGA Hardware-Konfiguration verschiedene Signalwerte aus dem FPGA nach Bedarf ausgelesen werden.

Die Konfigurationsebene betrifft eine logische Ebene des FPGA, die zur Initialisierung des FPGA dient. Während eines initialen Konfigurationsprozesses werden die Konfigurationsdaten in den Konfigurationsspeicher geschrieben, wodurch sich die funktionale Ebene im Anschluss wie modelliert verhält. Während des Betriebs können dann z.B. durch einen Trigger alle Registerinhalte der funktionalen Ebene zurück in die Konfigurationsebene gespiegelt werden. Der Inhalt des Konfigurationsspeichers kann anschließend ausgelesen werden, um daraus den Signalwert zu bestimmen. Umgekehrt können während des Betriebs dann z.B. durch einen Trigger alle Inhalte des Konfigurationsspeichers aus der Konfigurationsebene in Registerinhalte der funktionalen Ebene übertragen werden. Ein solcher Trigger kann bspw. ein Reset-Signal sein. Ein Reset-Signal kann für einen Teil des FPGAs gesetzt werden oder explizit für eine Anzahl von Registern im FPGA Programm eingestellt sein. Für Änderungen an Look-up Tables und Multiplexern kann ein solcher Trigger unnötig sein, wenn Änderungen in der Konfigurationsebene sich direkt auf die funktionale Ebene auswirken.

Die Auswahl des Signalwerts kann beliebig während der Laufzeit geändert werden. Bevorzugt erfolgt ein Zugriff auf eine Mehrzahl Signalwerte als Rücklesedaten und/oder als Rückschreibedaten.

Die Rücklesedaten und/oder Rückschreibedaten können eine beliebige Dateneinheit des FPGA beinhalten. Die Rücklesedaten und/oder Rückschreibedaten können einzelne Registerwerte oder größere Speicherblöcke des FPGA umfassen. Die Speicherblöcke können beispielsweise Readback-Spalten des FPGA sein. Rücklesedaten und Rückschreibedaten sind strukturell gleich und werden lediglich begrifflich unterschieden. Vorzugsweise sind die zu verändernden Signalwerte als Konstanten im FPGA implementiert, beispielsweise als Simulink Konstant Block, die lediglich während der Entwicklung angepasst werden müssen.

Die Reihenfolge des angegebenen Verfahrens kann prinzipiell variieren und ist nicht auf die hier angegebene Reihenfolge beschränkt. Insbesondere kann das Verfahren nach dem Laden und Ausführen einer FPGA Hardware Konfiguration zur Veränderung eines Signalwerts und/oder zum Zugriff darauf durchgeführt, um wiederholt auf Signalwerte zuzugreifen oder um Signalwerte zu verändern.

Es ergibt sich ein schreibender Zugriff auf das FPGA. Dieser Zugriff erfolgt zur Laufzeit ohne Beeinflussung des FPGA. Die beschriebenen Details gelten jeweils entsprechend für den lesenden Zugriff auf Signalwerte des FPGA wie auch für den schreibenden Zugriff zur Veränderung eines Signalwerts und sind jeweils individuell entsprechend anwendbar.

Es erfolgt beim schreibenden Zugriff zur Veränderung eines Signalwerts des FPGA eine dynamische, partielle Re-Konfiguration des FPGAs, wobei die jeweils relevanten Anteile im FPGA, welche den Signalwert umfassen, zur Laufzeit überschrieben werden. Dabei kann beispielsweise ein Simulink Konstant Block oder eine beliebige andere Modellierung eines Signalwertes auf eine re-konfigurierbare Look-Up Table, ein re- konfigurierbares Register oder einen re-konfigurierbaren Multiplexer abgebildet werden. Mittels partieller, dynamischer Re-Konfiguration der Look-Up Table, des Registers bzw. des Multiplexers kann der abgebildete Signalwert zur Laufzeit des FPGA verändert werden. Signalwerte, die mehrere Bits umfassen, können ggf. aufgeteilt auf mehrere Elemente abgebildet werden. Je nach genutztem FPGA und FPGA-Programm kann eine unterschiedliche Abbildung der Signalwerte auf FPGA Elemente vorteilhaft sein. Durch eine Analyse vor dem Build des FPGA Programms kann eine vorteilhafte Abbildung bestimmt werden.

Die Datenverarbeitungseinrichtung kann prinzipiell beliebig ausgeführt sein. Das FPGA ist typischerweise als Erweiterungsmodul in der Datenverarbeitungseinrichtung angeordnet oder mit dieser verbunden. Die Datenverarbeitungseinrichtung kann mit einem entfernten Steuerungsrechner über eine Datenverbindung verbunden sein. Besonders bevorzugt erfolgt ein Zugriff auf den Signalwert über eine Applikation auf dem Steuerungsrechner.

Die Darstellung des Signalwerts kann als graphische Darstellung erfolgen. Dabei kann der Signalwert vorzugsweise aus einer Liste per "Drag and Drop" auf dargestellte Instrumente zur Anzeige von Signalwerten gezogen werden. Umgekehrt kann ebenfalls ein zu verändernder Signalwert aus der Liste per "Drag and Drop" ausgewählt werden. Ebenfalls kann ein Wert für einen zu verändernden Signalwert per "Drag and Drop" auf einen ausgewählten Signalwert gesetzt werden.

Das Auslesen der Zustandsdaten aus dem Konfigurationsspeicher als Rücklesedaten beinhaltet keine Veränderung der Daten, sondern betrifft nur eine begriffliche Definition. Entsprechendes gilt für die Rückschreibedaten. Der Begriff der Rückschreibedaten soll lediglich angeben, dass ein Signalwert in das FPGA geschrieben wird, um den Signalwert in dem FPGA zu verändern.

Das Bestimmen des Signalwertes aus den Rücklesedaten und/oder das Bestimmen von Rückschreibedaten aus dem Signalwert kann prinzipiell an beliebiger Stelle erfolgen, beispielsweise in dem FPGA, der CPU der Datenverarbeitungseinrichtung oder dem Steuerungsrechner. Entsprechend können die Zustandsdaten, die Registerdaten oder der Signalwert jeweils wie erforderlich übertragen werden.

Ein lesender und/oder schreibender Zugriff auf den Konfigurationsspeicher des FPGA von außerhalb des FPGA erfolgt über eine Schnittstelle. Eine übliche Architektur des Konfigurationsspeichers umfasst eine Schnittstelle mit 32 Bit Breite und einer Taktfrequenz von 100 MHz mit einer minimalen Auslesemenge von einem Frame. Entsprechendes gilt für den schreibenden Zugriff. Damit ist eine Verwendung des Verfahrens im Sinne eines FPGA Debugger oder FPGA Scope mit einem zyklengenauen Zugriff im FPGA Takt mit heutzutage üblichen FPGAs nicht möglich. Ein Frame kann neben Registerwerten Informationen zu einer Look-Up Table sowie zur Multiplexer- bzw. Verdrahtungskonfiguration enthalten. Das Bestimmen des Signalwertes aus den Rücklesedaten umfasst beispielsweise das Auffinden und Extrahieren von Registerwerten aus einem Frame. Entsprechend umfasst das Bestimmen von Rückschreibedaten aus dem Signalwert beispielsweise das Auffinden von Registerwerten in einem Frame und das Setzen der Registerwerte gemäß dem Signalwert. Ein lesender und/oder schreibender Zugriff auf den Konfigurationsspeicher des FPGA ist auch von innerhalb des FPGA über eine interne Schnittstelle möglich. Eine solche interne Schnittstelle stellt bspw. der "internal configuration access port" (ICAP) der Firma Xilinx dar.

In vorteilhafter Ausgestaltung der Erfindung umfasst das Verfahren vor dem Übertragen der Zustandsdaten aus dem Konfigurationsspeicher in die funktionale Ebene des FPGA den zusätzlichen Schritt des Übertragens von Zustandsdaten aus der funktionalen Ebene des FPGA in den Konfigurationsspeicher in dessen Konfigurationsebene. Entsprechend kann beispielsweise eine Initialisierung der Konfigurationsebene des FPGA durchgeführt werden, bevor die Rückschreibedaten als Zustandsdaten in die Konfigurationsebene des FPGA übertragen werden. Auch kann eine Veränderung des Signalwerts beispielsweise ausgehend von dem zuvor ausgelesenen Signalwert erfolgen. Wenn das Übertragen der Zustandsdaten aus dem Konfigurationsspeicher in die funktionale Ebene des FPGA in Einheiten erfolgt, die größer als der zu verändernde Signalwert sind, kann der Konfigurationsspeicher durch das vorherige Übertragen der Zustandsdaten der funktionalen Ebene initialisiert werden, so dass nach dem Übertragen der Zustandsdaten in die funktionale Ebene außer dem veränderten Signalwert der ursprüngliche Zustand wieder hergestellt wird. Entsprechend kann der Signalwert verändert werden, ohne dass das FPGA zur Laufzeit in seinem übrigen Verhalten verändert wird. Dies gilt insbesondere, wenn die in die funktionale Ebene zu übertragenden Zustandsdaten konstante Werte repräsentieren, die sich zur Laufzeit nicht ändern. Prinzipiell gilt dies auch, wenn zwischen dem Übertragen der Zustandsdaten in die Konfigurationsebene und dem Übertragen der Zustandsdaten in die funktionale Ebene keine Veränderung der funktionalen Ebene erfolgt ist. Bei dem Übertragen der Zustandsdaten in die funktionale Ebene des FPGA können die Rückschreibedaten zu dem Signalwert zusätzliche Informationen umfassen. Daher werden vorzugsweise zuerst die Zustandsdaten ausgelesen als Basis für die Rückschreibedaten, und der Signalwert wird in diese Zustandsdaten eingefügt. Damit kann die Datenintegrität des FPGA gewährleistet werden.

Es erfolgt bereits bei der Erstellung des FPGA-Programms eine gemeinsame Anordnung von Signalwerten, die verändert werden können, separat von Elementen des FPGA in der funktionalen Ebene, deren Konfiguration sich zur Laufzeit ändern kann, beispielsweise in der Art von Variablen. So kann bei einer partiellen Re-Konfiguration sichergestellt werden, dass nicht unbeabsichtigt Teile des FPGA, die sich zur Laufzeit geändert haben, überschrieben werden. Da der FPGA während des Verfahrens weiterläuft könnten sich sonst zwischen dem Übertragen der Zustandsdaten aus der funktionalen Ebene und dem Übertragen der Rückschreibedaten in die funktionale Ebene Änderungen durch die Funktion des FPGAs ergeben, die durch das beschriebene Verfahren rückgängig gemacht werden.

Wenn sich in dem zu schreibenden Bereich keine Elemente befinden, die sich zur Laufzeit ändern, ist es nicht notwendig vor jeder Änderung des Signalwertes die Zustandsdaten des zu schreibenden Bereichs in die Konfigurationsebene zu übertragen und auszulesen. Es genügt prinzipiell ein einmaliges Auslesen der Zustandsdaten, da sich die Zustandsdaten während der Laufzeit des FPGAs nicht ändern.

Da die Konfiguration der Elemente bei der Initialisierung des FPGA festgelegt wird, ist es alternativ möglich, die Grundinitialisierung des FPGA zu speichern und diese Werte beim Beschreiben des Bereichs der Konfigurationsebene zu verwenden.

In vorteilhafter Ausgestaltung der Erfindung umfasst der der Schritt des Bestimmens der Rückschreibedaten aus dem Signalwert das Abbilden des Signalwerts auf die Rückschreibedaten. In vorteilhafter Ausgestaltung der Erfindung umfasst der Schritt des Bestimmens des Signalwertes aus den Rücklesedaten das Abbilden der Rücklesedaten auf den Signalwert. Die Abbildung zur Bestimmung der Rückschreibedaten aus dem Signalwert bzw. des Signalwertes aus den Rücklesedaten wird in Übereinstimmung mit der Repräsentation des Signalwerts in dem FPGA als Register, Look-up Table, Multiplexer oder durch die Verdrahtung realisiert. Beispielsweise stellen die Register Speicher in der funktionalen Ebene dar, deren Daten einfach kopiert und zur Bestimmung des Signalwerts genutzt werden können. Dies ermöglicht die Identifikation der Daten zur Bestimmung des Signalwerts. Da keine einzelnen Register ausgelesen oder beschrieben werden können, sondern die Konfigurationsebene nur Bereichsweise bearbeitet werden kann, muss eine Abbildung des Signalwertes auf die Konfigurationsbits des Bereichs erfolgen.

In vorteilhafter Ausgestaltung der Erfindung umfasst der Schritt des Bestimmens der Rückschreibedaten aus dem Signalwert das Bestimmen wenigstens eines Registerwerts des FPGA aus dem Signalewert. In vorteilhafter Ausgestaltung der Erfindung umfasst der Schritt des Bestimmens des Signalwertes aus den Rücklesedaten das Bestimmen des Signalwerts aus wenigstens einem Registerwert des FPGA. Die Organisation des Signalwerts in dem wenigstens einen Register kann beliebig sein, weshalb die Registerinhalte verarbeitet werden müssen, um den Signalwert zu bestimmen oder aus dem Registerinhalt die Zustandsdaten für die gewünschte Veränderung des Signalwerts zu bestimmen. Insbesondere kann der Signalwert auf eine Mehrzahl Register verteilt sein, und die Inhalte der Register werden gemeinsam verarbeitet, um den Signalwert zu bestimmen oder aus mehreren Registerinhalten die Zustandsdaten für die gewünschte Veränderung des Signalwerts zu bestimmen.

In vorteilhafter Ausgestaltung der Erfindung umfasst der Schritt des Schreibens der Rückschreibedaten als Zustandsdaten in einen Konfigurationsspeicher des FPGA das Ermitteln von für das Verändern des Signalwerts erforderlichen Bereichen des Konfigurationsspeichers und das Schreiben von Zustandsdaten der erforderlichen Bereiche des Konfigurationsspeichers als Rückschreibedaten. In vorteilhafter Ausgestaltung der Erfindung umfasst der Schritt des Auslesens der Zustandsdaten aus dem Konfigurationsspeicher als Rücklesedaten das Ermitteln von für das Bestimmen des Signalwerts erforderlichen Bereichen des Konfigurationsspeichers und das Auslesen von Zustandsdaten der erforderlichen Bereiche des Konfigurationsspeichers als Rücklesedaten. Die Adressen des Konfigurationsspeichers, über die die Konfigurationsbits von Register, Look-Up Table oder Multiplexer, in denen der Signalwert kodiert ist, zu adressieren sind, werden bestimmt und zur Laufzeit des FPGA in Abhängigkeit von dem zu verstellenden Signalwert ausgewählt, so dass der schreibende oder lesende Zugriff auf den Konfigurationsspeicher ohne vorherige Anpassungen der FPGA Hardware-Konfiguration erfolgen kann. Durch das Ermitteln der erforderlichen Bereiche kann das Auslesen und/oder Schreiben der Zustandsdaten auf diese Bereiche beschränkt werden, wodurch wenige Daten ausgelesen, übertragen, verarbeitet und/oder geschrieben werden müssen.

In vorteilhafter Ausgestaltung der Erfindung umfasst der Schritt des Übertragens der Zustandsdaten aus dem Konfigurationsspeicher in die funktionale Ebene des FPGA das Ermitteln von für das Schreiben der Zustandsdaten erforderlichen Teilen der funktionalen Ebene des FPGA und das Übertragen dieser Teile der Zustandsdaten in die funktionale Ebene. In vorteilhafter Ausgestaltung der Erfindung umfasst der Schritt des Übertragens von Zustandsdaten aus einer funktionalen Ebene des FPGA in einen Konfigurationsspeicher in dessen Konfigurationsebene das Ermitteln von für das Bestimmen des Signalwerts erforderlichen Teilen der Zustandsdaten und das Sichern dieser Teile der Zustandsdaten in seinen Konfigurationsspeicher. Zu übertragende und/oder zu schreibende Bereiche/Teile werden zur Laufzeit ermittelt, so dass das Übertragen und/oder Schreiben der Zustandsdaten ohne vorherige Anpassungen der FPGA Hardware-Konfiguration erfolgen kann. Durch das Ermitteln der erforderlichen Bereiche/Teile kann das Sichern und/oder Speichern der Zustandsdaten auf diese Bereiche beschränkt werden, wodurch wenige Daten gesichert und/oder gespeichert werden müssen.

In vorteilhafter Ausgestaltung der Erfindung umfasst das Ermitteln von für das Verändern des Signalwerts erforderlichen Bereichen der Konfigurationsspeichers und/oder das Ermitteln von für das Schreiben der Zustandsdaten erforderlichen Teilen der funktionalen Ebene des FPGA das Identifizieren der jeweiligen Bereiche über eine Identifikationsnummer. Die Identifikationsnummer kann prinzipiell zu einem beliebigen Zeitpunkt bestimmt werden. Vorzugsweise wird die Identifikationsnummer unter Verwendung eines Modells der FPGA Hardware-Konfiguration bestimmt. Besonders bevorzugt ist jedem Bereich eine eindeutige Identifikationsnummer zugeordnet, über die der Zugriff erfolgt. Signalwerte können damit beispielsweise einem Bereich des Konfigurationsspeichers über dessen Identifikationsnummer adressiert werden. Die Identifikationsnummer kann beispielsweise als Block ID für die Identifizierung eines Modellblocks ausgeführt sein. Die Block ID kann über die verschiedenen Schritte der Erstellung des FPGA Programms nachverfolgt werden. Über die Block ID ist so eine einfache Zuordnung von einem FPGA Element wie einem Register, einer Look-up Table oder einem Multiplexer zu einem Modellblock möglich.

In vorteilhafter Ausgestaltung der Erfindung umfasst der Schritt des Setzens des Signalwertes zur Übertragung an das FPGA das Bereitstellen einer Liste verfügbarer Signalwerte und die Auswahl eines Signalwerts aus dieser Liste. In vorteilhafter Ausgestaltung der Erfindung umfasst der Schritt des Anforderns eines Signalwertes des FPGA das Bereitstellen einer Liste verfügbarer Signalwerte und die Auswahl eines Signalwerts aus dieser Liste. Die Liste kann prinzipiell zu einem beliebigen Zeitpunkt erstellt werden. Vorzugsweise wird die Liste unter Verwendung eines Modells der FPGA Hardware-Konfiguration erstellt. Besonders bevorzugt ist jedem Signalwert eine eindeutige Identifikationsnummer zugeordnet, über die der Zugriff erfolgt.

In vorteilhafter Ausgestaltung der Erfindung umfasst der Schritt des Übertragens der Zustandsdaten aus dem Konfigurationsspeicher in die funktionale Ebene des FPGA das Senden eines Reset-Signals an das FPGA. Das Reset-Signal ist das Signal, welches das Übertragen der Zustandsdaten aus dem Konfigurationsspeicher in die funktionale Ebene des FPGA startet. Eine entsprechende Übertragung kann in kurzer Zeit erfolgen, beispielsweise wenigen Zyklen, wobei durch das Setzen des Reset-Signals der Zeitpunkt zum Übertragen der Zustandsdaten aus dem Konfigurationsspeicher in die funktionale Ebene gesteuert werden kann. Das Reset-Signal kann ein globales Reset-Signal sein, welches auf alle Elemente des FPGA, deren Bereiche der Konfigurationsebene an dem Reset teilnehmen, wirkt.

In vorteilhafter Ausgestaltung der Erfindung umfasst der Schritt des Sendens eines Reset-Signals an das FPGA das Senden eines Reset-Signals zum partiellen Übertragen der Zustandsdaten aus dem Konfigurationsspeicher in die funktionale Ebene des FPGA. Durch das partielle Übertragen der Zustandsdaten kann die Veränderung des Signalwerts effizient durchgeführt werden. Es sind nur wenige Ressourcen des FPGA erforderlich, wodurch insbesondere eine Anwendung in einem Echtzeitsystem erleichtert wird. Durch eine dedizierte Resetleitung, die nur die Register anspricht, die verstellbar sein sollen, lassen sich unerwünschte Effekte, wie sie durch ein globales Reset entstehen könnten vermeiden.

Werden die zu verstellenden Signalwerte in Form von Look-Up Tables oder Multiplexern implementiert, so kann auf eine Resetleitung verzichtet werden, wenn die Daten der Konfigurationsebene direkt von der Look-Up Table oder den Multiplexern übernommen werden.

In vorteilhafter Ausgestaltung der Erfindung umfasst der Schritt des Ausführens der FPGA Hardware Konfiguration auf dem FPGA das Ausführen der Hardware Konfiguration als Echtzeitanwendung, und das Verfahren zum Verändern eines Signalwerts eines FPGA wird zur Laufzeit der Echtzeitanwendung durchgeführt. Echtzeitanwendungen sind sehr zeitkritisch, so dass eine Veränderung von bereitgestellten Ressourcen bereits zur Veränderung des Verhaltens der Echtzeitanwendung führen kann. Unter Verwendung des erfindungsgemäßen Verfahrens kann ein Signalwert verändert werden oder ein lesender Zugriff darauf erfolgen, ohne dass Ressourcen der FPGA Hardware Konfiguration verändert werden müssen. Das Verändern des Signalwerts kann unabhängig von der Implementierung der FPGA Hardware Konfiguration erfolgen, so dass keine relevanten Einflüsse auf die FPGA Hardware Konfiguration durch das Verändern eines Signalwerts erfolgen.

Weiterhin ist ein Verfahren zum Durchführen eines FPGA Builds basierend auf einem FPGA Modell in einer Hardwarebeschreibungssprache angegeben, umfassend die Schritte Erstellen einer FPGA Hardware-Konfiguration, Ermitteln von Speicherstellen eines Konfigurationsspeichers für Zustandsdaten wenigstens eines Signalwerts basierend auf der FPGA Hardware-Konfiguration, und Erstellen einer Liste mit zur Laufzeit zugreifbaren Signalwerten und den dazu korrespondierenden Speicherstellen.

Erfindungsgemäß ist außerdem ein Verfahren zum Durchführen eines FPGA Builds basierend auf einem FPGA Modell in einer Hardwarebeschreibungssprache angegeben, umfassend die Schritte Erstellen einer FPGA Hardware-Konfiguration mit einer Mehrzahl Signalwerte, Anordnung von Signalwerten in benachbarten Bereichen der FPGA Hardware-Konfiguration, Ermitteln von Speicherstellen eines Konfigurationsspeichers für Zustandsdaten der Mehrzahl Signalwerte basierend auf der FPGA Hardware-Konfiguration, und Erstellen einer Liste mit zur Laufzeit zugreifbaren und/oder veränderbaren Signalwerten und den dazu korrespondierenden Speicherstellen.

Die Grundidee dieses Verfahrens ist also, bereits bei der Erstellung einer FPGA Hardware-Konfiguration erforderliche Daten über Signalwerte zu erfassen und derart zu verarbeiten, dass der Signalwert basierend auf erfassten Zustandsdaten zur Laufzeit des FPGA gebildet werden können. Umgekehrt kann durch die bekannte Beziehung zwischen Zustandsdaten und Signalwerten auch ein Signalwert in dem FPGA auf einfache Weise verändert werden.

Zusätzlich ist durch die benachbarte Anordnung von Signalwerten gewährleistet, dass der Zugriff auf diese Signalwerte, entweder zum lesenden Zugriff oder zum Verändern der Signalwerte, auf einfache Weise und unter Verwendung von nur wenigen Ressourcen erfolgen kann.

Speicherstellen sind vorzugsweise Register des FPGA. Register können im Modell explizit modelliert werden oder beispielsweise durch Blöcke mit Verzögerung implizit modelliert werden. Das Modell wird vorzugsweise graphisch erzeugt.

Die Reihenfolge des angegebenen Verfahrens kann prinzipiell variieren und ist nicht auf die hier angegebene Reihenfolge beschränkt. Beispielsweise kann das Erstellen einer Liste mit zur Laufzeit zugreifbaren und/oder mit zur Laufzeit veränderbaren Signalwerten ausgehend von dem Modell in der Hardwarebeschreibungssprache zu einem früheren Zeitpunkt erfolgen.

Vorzugsweise ist das hier angegebene Verfahren zum Durchführen eines FPGA Builds Teil eines Build-Verfahrens für eine Datenverarbeitungseinrichtung mit einem FPGA, wobei die Datenverarbeitungseinrichtung das FPGA umfasst oder damit verbunden ist. Bei diesem Verfahren wird zusätzlich ein Build für die CPU der Datenverarbeitungseinrichtung durchgeführt, wobei in einem CPU Trace File Generator eine Erzeugung eines CPU Trace Files erfolgt. Zusätzlich wird die Liste mit zur Laufzeit zugreifbaren Signalwerten und den dazu korrespondierenden Speicherstellen, die hier als "Logic Allocation File" bezeichnet ist, in ein maschinenlesbares File umgewandelt. Zusätzlich wird ein Trace File für das FPGA äquivalent zu dem Trace File der CPU erzeugt. In einem weiteren Schritt werden die Trace Files von CPU und FPGA in einem Trace File Merger zusammengefügt. Dadurch kann beispielsweise von einem Steuerungsrechner ein Zugriff auf Signalwerte und/oder eine Veränderung eines Signalwerts unabhängig von der Implementierung für die Ausführung in der CPU oder dem FPGA erfolgen.

In vorteilhafter Ausgestaltung der Erfindung umfasst das Verfahren den zusätzlichen Schritt des Implementierens eines Reset-Signals zum Übertragen von Zustandsdaten aus dem Konfigurationsspeicher in die funktionale Ebene des FPGA, wobei das Übertragen von Zustandsdaten aus dem Konfigurationsspeicher in die funktionale Ebene des FPGA das partielle Übertragen der Zustandsdaten aus den benachbarten Bereichen der FPGA Hardware-Konfiguration mit den Signalwerten umfasst. Das Reset-Signal ist das Signal, welches das Übertragen der Zustandsdaten aus dem Konfigurationsspeicher in die funktionale Ebene des FPGA startet. Eine entsprechende Übertragung kann in kurzer Zeit erfolgen, beispielsweise wenigen Zyklen, wobei durch das Setzen des Reset-Signals der Zeitpunkt zum Übertragen der Zustandsdaten aus dem Konfigurationsspeicher in die funktionale Ebene gesteuert werden kann. Dabei können während des Betriebs durch partielles, dynamisches Rekonfigurieren des FPGAs die jeweils relevanten Anteile im FPGA überschrieben werden. Der Signalwert, beispielsweise ein Simulink Konstant Block, wird auf das FPGA, d.h. die rekonfigurierbare Look-up Table, das Register oder den Multiplexer abgebildet. Anschließend wird der Signalwert mittels partieller, dynamischer Rekonfiguration auf einen beliebigen Wert verändert.

In vorteilhafter Ausgestaltung der Erfindung umfasst der Schritt des Implementierens eines Reset-Signals zum Übertragen von Zustandsdaten aus dem Konfigurationsspeicher in die funktionale Ebene des FPGA das Implementieren eines Reset-Signals zum partiellen Übertragen der Zustandsdaten aus dem Konfigurationsspeicher in die funktionale Ebene des FPGA. Durch das partielle Übertragen der Zustandsdaten kann die Veränderung des Signalwerts effizient durchgeführt werden. Es sind nur wenige Ressourcen des FPGA erforderlich, wodurch insbesondere eine Anwendung in einem Echtzeitsystem erleichtert wird.

In vorteilhafter Ausgestaltung der Erfindung umfasst der Schritt des Erstellens einer Liste mit zugreifbaren und/oder veränderbaren Signalwerten und den dazu korrespondierenden Speicherstellen das Ermitteln einer Verknüpfung der Speicherstellen zur Bildung des Signalwerts. Die Liste enthält somit konkrete Angaben, wie ein Signalwert aus Zustandsdaten ermittelt wird.

In vorteilhafter Ausgestaltung der Erfindung umfasst das Verfahren den zusätzlichen Schritt des Erzeugens eines FPGA-Codes zum Bestimmen eines Signalwertes, wobei der FPGA-Code das Auslesen der Zustandsdaten aus dem Konfigurationsspeicher als Rücklesedaten und das Bestimmen des Signalwertes aus den Rücklesedaten basierend auf der Liste mit auslesbaren Signalwerten und den dazu korrespondierenden Speicherstellen umfasst. Eine anschließende Verarbeitung der Zustandsdaten zur Bestimmung des Signalwertes kann somit vollständig in dem FPGA durchgeführt werden. Entsprechend ist von dem FPGA nur der bestimmte Signalwert zu Übertragen, wodurch dessen Schnittstelle entlastet wird.

In vorteilhafter Ausgestaltung der Erfindung umfasst das Verfahren den zusätzlichen Schritt des Erzeugens eines FPGA-Codes zum Verändern eines Signalwertes, wobei der FPGA-Code das Bestimmen von Rückschreibedaten aus dem Signalwert basierend auf der Liste mit auslesbaren Signalwerten und den dazu korrespondierenden Speicherstellen und das Schreiben der Rückschreibedaten als Zustandsdaten in den Konfigurationsspeicher des FPGA umfasst. Eine Verarbeitung des Signalwertes zur Bestimmung der Zustandsdaten kann somit vollständig in dem FPGA durchgeführt werden. Entsprechend ist nur der zu verändernde Signalwert an das FPGA zu Übertragen, wodurch dessen Schnittstelle entlastet wird. Das FPGA kann seinen eigenen Konfigurationsspeicher über eine interne Schnittstelle auslesen und beschreiben. Ein solche interne Schnittstelle stellt bspw. der "internal configuration access port" (ICAP) der Firma Xilinx dar. Alternativ ist eine Implementierung mit einem Mikroprozessor, beispielsweise ein Microblaze, möglich.

Die Konfigurationsebene eines FPGA kann nur spaltenweise über ein Readback gelesen oder über part. Rekonfiguration beschrieben werden. Im Folgenden werden diese Spalten Readback-Spalten genannt. In vorteilhafter Ausgestaltung der Erfindung umfasst das Verfahren den zusätzlichen Schritt des Optimierens der FPGA Hardware-Konfiguration mit der Anordnung von Speicherstellen, die Zustandsdaten für einen Signalwert beinhalten, in einer Readback-Spalte des FPGA. Durch die Anordnung in einer Readback-Spalte wird der Zugriff auf die Zustandsdaten für einen Signalwert und/oder das Verändern eines Signalwerts in dem FPGA beschleunigt. Bei einer Anordnung aller Speicherstellen für einen Signalwert innerhalb einer Readback-Spalte kann darauf mit einer Operation zugegriffen werden. Es erfolgt somit eine Sortierung von Speicherstellen in Readbackspalten vor der Erzeugung der FPGA Hardware-Konfiguration.

In vorteilhafter Ausgestaltung der Erfindung umfasst das Verfahren den zusätzlichen Schritt des Optimierens der FPGA Hardware-Konfiguration mit der Anordnung von Speicherstellen, die Zustände für einen Signalwert beinhalten, in benachbarten Bereichen des FPGA. Benachbarte Bereiche können eine einzelne Readback-Spalte des FPGA betreffen, oder eine Mehrzahl von benachbarten Readback-Spalten. Durch die benachbarte Anordnung wird der Zugriff auf die Speicherstellen beschleunigt. Bei einer Anordnung von Speicherstellen für zwei Signalwerte innerhalb einer Readback-Spalte kann auf beide mit einer Operation zugegriffen werden. Entsprechendes gilt für schreibende Zugriffe, wobei nur Signalwerte in das FPGA geschrieben werden können, die in einer Speicherstelle zumindest temporär darin vorliegen.

In vorteilhafter Ausgestaltung der Erfindung umfasst das Verfahren den zusätzlichen Schritt des Hinzufügens von Speicherstellen an Ausgängen von logischen Blöcken zur Bereitstellung von Zustandsdaten. Die Speicherstellen, üblicherweise Register, ermöglichen das Auslesen von Zustandsdaten, um daraus Signalwerte zu bestimmen. Bei erhöhter Anzahl von verfügbaren Zustandsdaten kann ein Zugriff auf eine erhöhte Anzahl Signalwerte erfolgen.

In vorteilhafter Ausgestaltung der Erfindung ist das FPGA ein Xilinx FPGA. Das Xilinx FPGA bietet neben der Möglichkeit der auch wiederholten Konfiguration des FPGAs ebenso die Möglichkeit des partiellen Auslesens und Konfigurierens des FPGAs während des Betriebs.

Nachfolgend wird die Erfindung unter Bezugnahme auf die anliegende Zeichnung anhand bevorzugter Ausführungsformen näher erläutert.

Es zeigen
- Fig. 1: eine schematische Darstellung eines Datenverarbeitungssystems mit einem Steuerungsrechner und einem Echtzeitsystem,
- Fig. 2: eine Detailansicht eines FPGA des Echtzeitsystems aus Fig. 1,
- Fig. 3: ein Diagramm eines Verfahrens zur Durchführung eines Builds für das Echtzeitsystem aus Fig. 1,
- Fig. 4: eine Detailansicht eines FPGA Builds aus Fig. 3,
- Fig. 5: eine Detailansicht der Organisation des Konfigurationsspeichers des FPGA aus Fig. 2 in Readback-Spalten,
- Fig. 6: eine Schematische Darstellung von relevanten Speicherinhalten in Readback-Spalten des Konfigurationsspeicher, wobei die linke Darstellung eine Verteilung ohne Optimierung, die mittlere Darstellung eine Optimierung mit einer Konzentration von relevanten Speicherstellen in Readback-Spalten und die rechte Darstellung eine Optimierung mit einer benachbarten Anordnung von relevanten Readback-Spalten zeigt,
- Fig. 7: ein Schema für ein XML-Modell,
- Fig. 8: eine Verteilung der Ergebnisse des Build Verfahrens aus Fig. 3 auf die verschiedenen Komponenten des Datenverarbeitungssystems aus Fig. 1,
- Fig. 9: ein Zeitdiagramm zum Übertragen von Zustandsdaten des FPGA an einen anfragenden Rechner,
- Fig. 10: ein Ablaufdiagramm eines Verfahrens zum Zugriff auf einen Signalwert eines FPGA gemäß einer bevorzugten Ausführungsform,
- Fig. 11: ein Ablaufdiagramm eines Verfahrens zum Verändern eines Signalwerts eines FPGA gemäß einer bevorzugten Ausführungsform,
- Fig. 12: eine schematische Darstellung einer Implementierung eines Signalwerts auf einem FPGA mittels eines Registers,
- Fig. 13: eine schematische Darstellung einer Implementierung eines Signalwerts auf einem FPGA mittels einer Look-up table,
- Fig. 14: eine schematische Darstellung einer Implementierung eines Signalwerts auf einem FPGA mittels eines Multiplexers,
- Fig. 15: eine schematische Darstellung einer Implementierung eines Signalwerts auf einem FPGA mittels Routing zu VCC/GND, und
- Fig. 16: ein Diagramm basierend auf dem Diagramm aus Fig. 3 eines Verfahrens zur Durchführung eines Builds für das Echtzeitsystem aus Fig. 1 mit zusätzlichen Details zur Modellierung eines Signals.

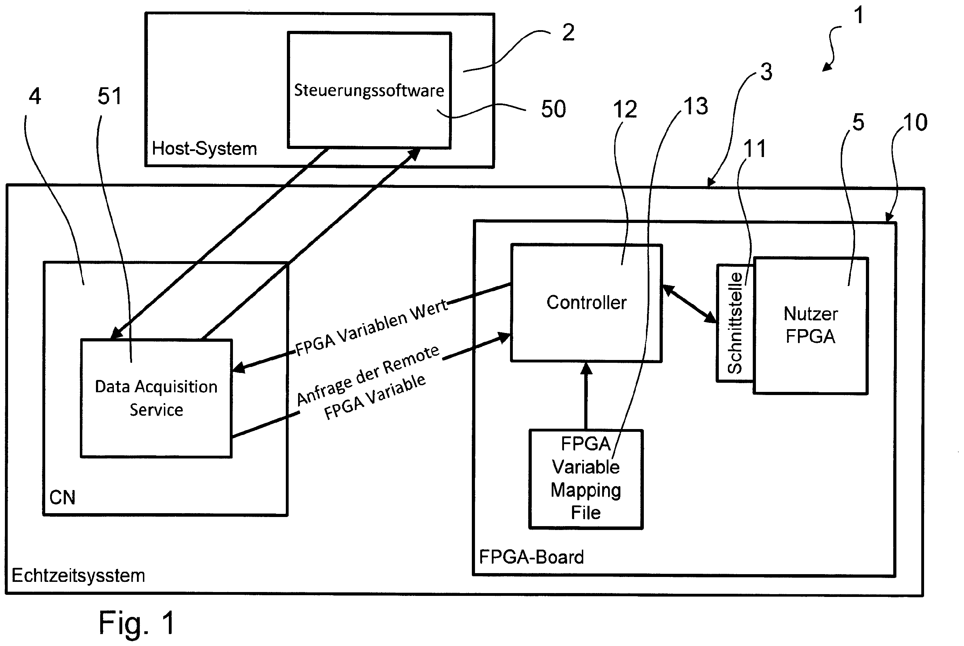

Die Figur 1 zeigt einen erfindungsgemäßen Aufbau eines Datenverarbeitungssystems 1 mit einem Steuerungsrechner 2, hier auch als Host-System gekennzeichnet, und einem Echtzeitsystem 3. Das Echtzeitsystem 3 ist mit dem Steuerungsrechner 2 über eine nicht explizit dargestellte Netzwerkverbindung verbunden.

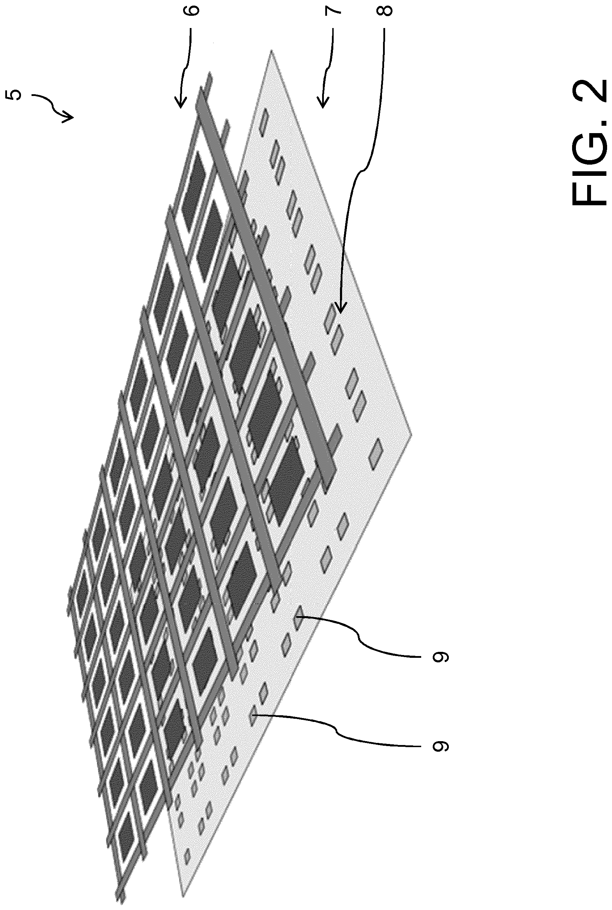

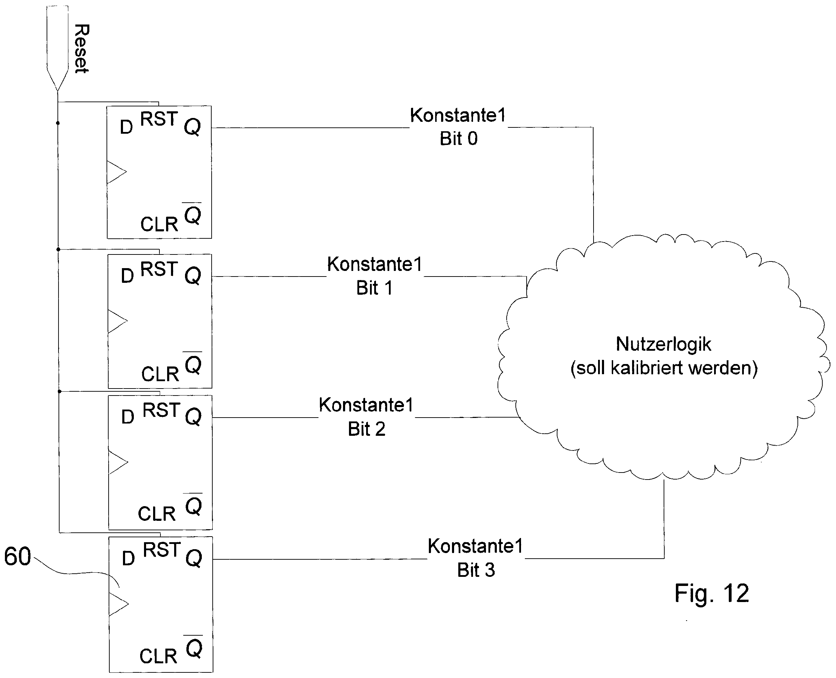

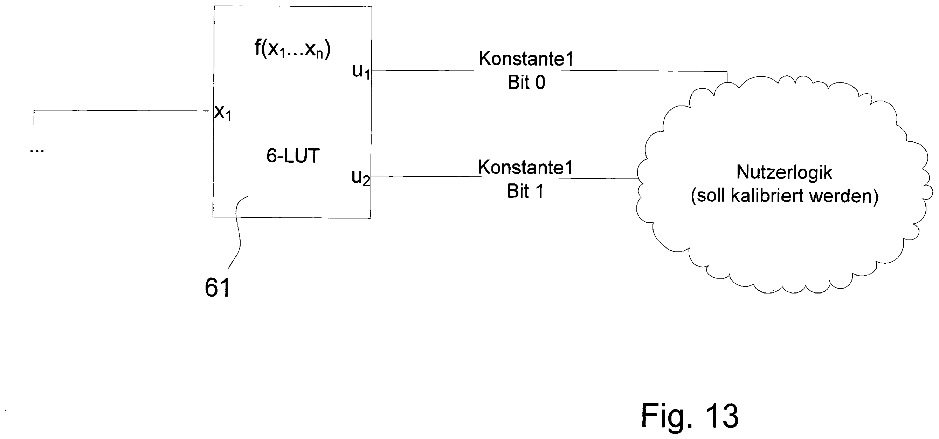

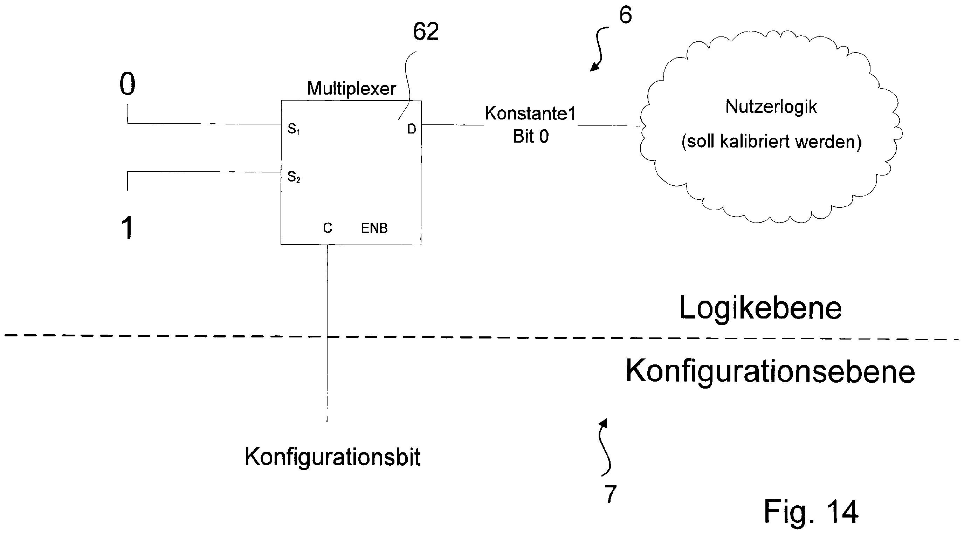

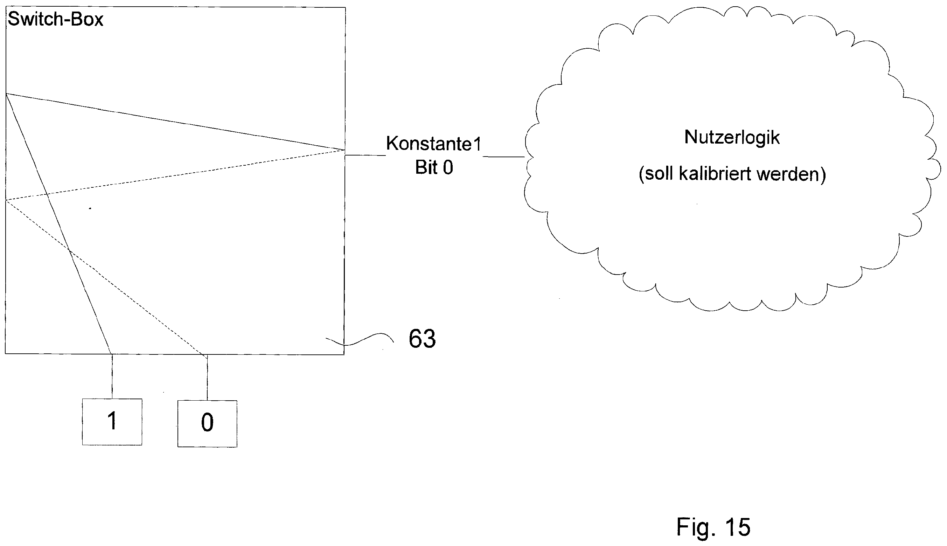

Das Echtzeitsystem 3 umfasst einem Rechenknoten 4, auch als CN gekennzeichnet, mit einer nicht dargestellten CPU sowie ein FPGA 5, das in diesem Ausführungsbeispiel ein Xilinx FPGA ist. Das Echtzeitsystem 3 ist hier eine beliebige Datenverarbeitungseinrichtung. Das FPGA 5 ist schematisch in Fig. 2 gezeigt und umfasst eine funktionale Ebene 6 und eine Konfigurationsebene 7. In der Konfigurationsebene 7 ist ein Konfigurationsspeicher 8 mit einer Mehrzahl Speicherstellen 9 angeordnet. Die Konfigurationsebene 7 ist eine logische Ebene des FPGA 5 zu dessen Initialisierung. Während eines initialen Konfigurationsprozesses werden Konfigurationsdaten in den Konfigurationsspeicher 8 geschrieben und in die funktionale Ebene 6 übertragen. Die Speicherstellen 9 entsprechen in diesem Ausführungsbeispiel Registern 60 des FPGA 5, wie beispielsweise in Fig. 12 gezeigt ist. Alternative Ausführungsformen betreffen eine Implementierung von Speicherstellen 9 mittels Look-up Table 61, wie in Fig. 13 dargestellt, Multiplexer 62, wie in Fig. 14 gezeigt, oder gemäß Fig. 15 mittels Routing zu VCC/GND, das in einer Switch-Box 63 implementiert ist, und eine alternative Verdrahtung zu einer Versorgungsspannung bzw. zu Masse als Implementierung elementarer, binärer Werte betrifft.

Das FPGA 5 ist auf einem FPGA-Board 10 angeordnet und über eine Schnittstelle 11 mit einem Controller 12 für den Zugriff auf die Schnittstelle 11 verbunden. Die Schnittstelle 11 hat hier eine Breite von 32 Bit bei einer Taktfrequenz von 100 MHz mit einer minimalen Auslesemenge von einem Frame. Ein Frame kann in beliebiger Kombination Registerwerte, Informationen zu einer Look-Up Table 61 und/oder zur Multiplexer- 62 bzw. Verdrahtungskonfiguration enthalten. Auf dem FPGA-Board 10 ist ein FPGA Variable Mapping File 13 für den Zugriff durch den Controller 12 gespeichert. Die nachfolgenden Ausführungen für den Zugriff auf einen Signalwert des FPGA 5 bzw. zum Verändern eines Signalwerts des PFGA 5 gelten jeweils entsprechend für das Verändern bzw. Zugriff. Der Signalwert kann dabei jeweils alternativ mittels Register 60, Look-up Table 61, Multiplexer 62 oder über Routing zu VCC/GND implementiert sein.

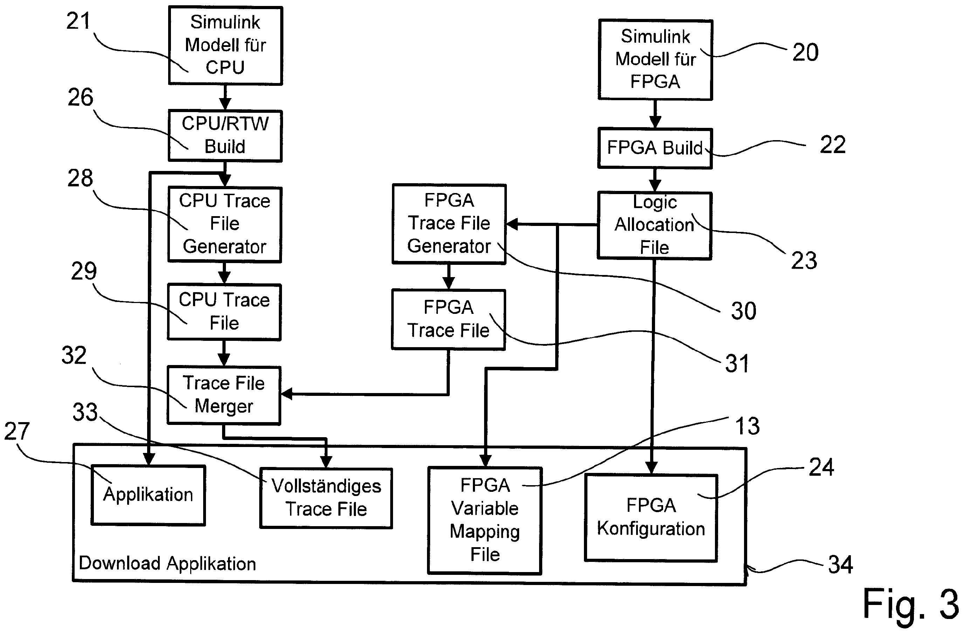

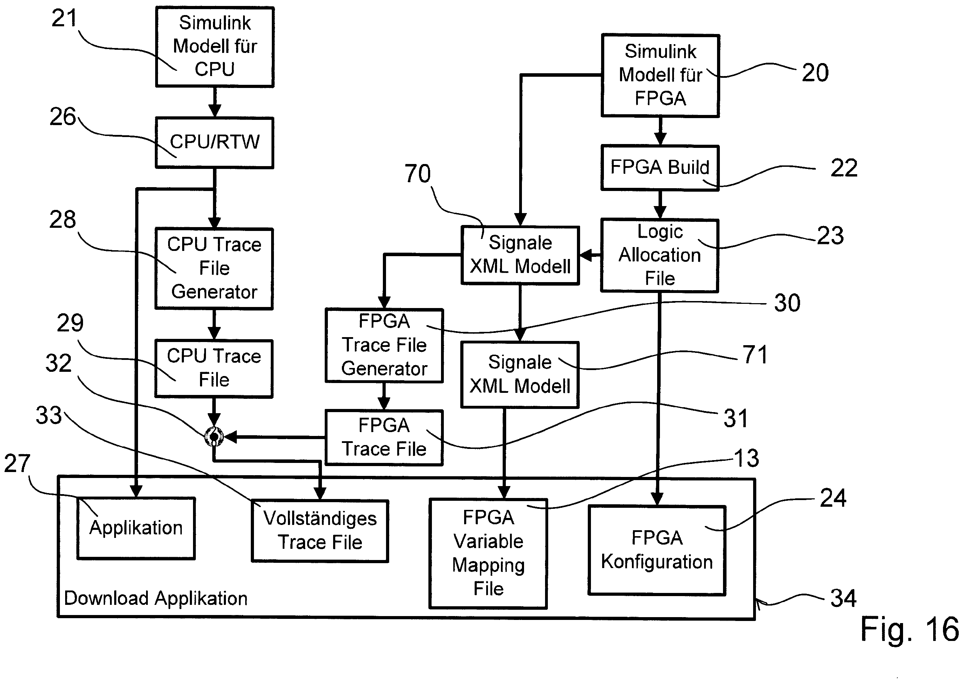

Für die Nutzung des Echtzeitsystems 3 wird, wie im Folgenden unter Bezug auf Fig. 3 bzw. Fig. 16 beschrieben, ein Build durchgeführt. Als Ausgangsbasis für den Build dienen ein FPGA Modell 20 sowie ein CPU-Modell 21, die beide mit Simulink erzeugt wurden. Aus dem FPGA Modell 20 werden in einem FPGA Build 22 über VHDL, einer verbreiteten Hardwarebeschreibungssprache, ein Logic Allocation File 23 und eine FPGA Hardware-Konfiguration 24 erzeugt. In dem Logic Allocation File 23 wird eine Liste mit Speicherstellen 9 des Konfigurationsspeichers 8 für Zustandsdaten von zur Laufzeit in dem FPGA 5 zugreifbaren Signalwerten gespeichert. Auch werden Verknüpfungen der Speicherstellen 9 zur Bildung der Signalwerte ermittelt und in dem Logic Allocation File 23 gespeichert, so dass ausgehend von dem Logic Allocation File 23 ein Signalwert aus Zustandsdaten bestimmt werden kann und umgekehrt.

Aus dem Logic Allocation File 23 wird das bereits zuvor genannte maschinenlesbare FPGA Variable Mapping File 13 erzeugt, welches die Zuordnungen von Speicherstellen 9 zu Signalwerten in einer maschinenlesbaren Form enthält. Dazu wird, wie in Fig. 16 im Detail gezeigt, ein Signale XML Model 70 unter Verwendung des FPGA Modells 20 und des Logic Allocation File 23 gebildet. Aus dem Signale XML Model 70 wird in einem Map File Generator 71 das FPGA Variable Mapping File 13 erzeugt. Aus dem CPU Modell 21 wird in einem CPU Build 26 eine auf der CPU des Echzeitsystems 3 ausführbare Applikation 27 erstellt. In einem CPU Trace File Generator 28 wird außerdem ausgehend von dem CPU Build 26 ein CPU Trace File 29 erzeugt. Analog wird in einem FPGA Trace File Generator 30, der das Signale XML Model 70 als Eingangsinformation erhält, ein FPGA Trace File 31 erzeugt. In einem weiteren Schritt werden die Trace Files 29, 31 in einem Trace File Merger 32 zu einem vollständigen Trace File 33 zusammengefügt.

Das Build Verfahren liefert als Gesamtergebnis eine Download Applikation 34 für das Echtzeitsystem 3 mit der Applikation 27, dem vollständigen Trace File 33, dem FPGA Variable Mapping File 13 und der FPGA Hardware-Konfiguration 24.

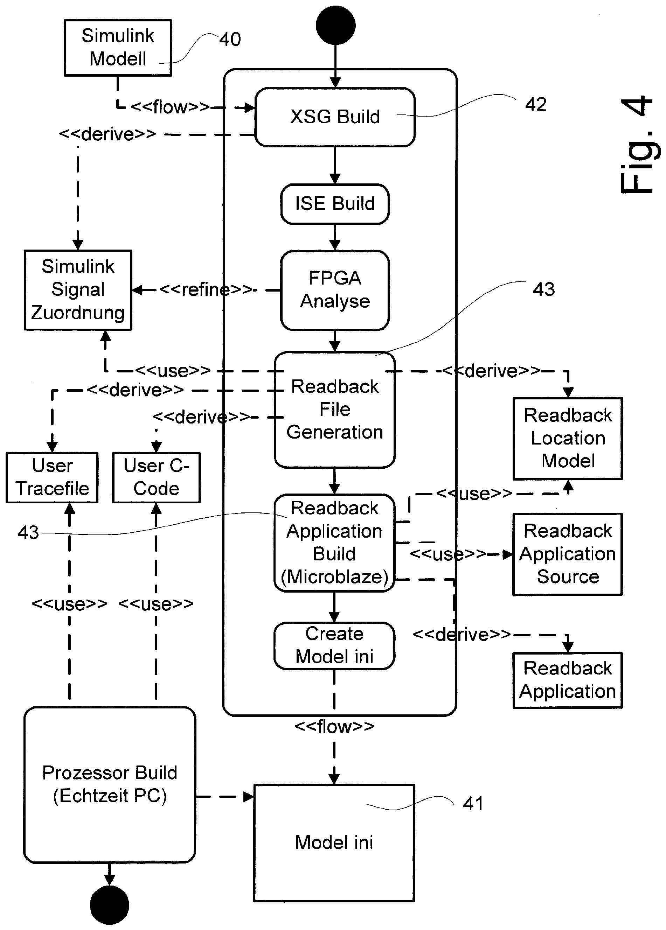

Der FPGA Build 22 ist im Detail in Fig. 4 gezeigt. Als Eingabe erhält der FPGA Build 22 ein Blockschaltbild 40 eines FPGA-Subsystems, welches eine Kombination von primitiven Blöcken wie Addition, Multiplikation, usw. umfassen. Das Ergebnis des Prozesses ist eine Model.ini-Datei 41, die den fertigen Bitstrom sowie eine Interfacebeschreibung enthält. Die Interfacebeschreibung enthält eine Liste aller Schnittstellen, die im FPGA-Subsystem instanziiert sind. Über diese Beschreibung können zu den FPGA-Schnittstellen korrespondierende CPU-Schnittstellen erzeugt werden. Im ersten Schritt des FPGA Build 22 wird aus dem Blockschaltbild 40 des FPGA-Subsystems durch den Xilinx System Generator (XSG) 42, eine HDL-Beschreibung generiert, die in diesem Ausführungsbeispiel eine VHDL-Beschreibung ist. Diese Beschreibung wird anschließend durch ein Synthesewerkzeug (XST) in eine Netzliste übersetzt.

Die Netzliste des Simulink-Modells wird nach dem XSG-Build mit den übrigen Framework-Komponenten zu einer vollständigen Netzliste zusammengeführt. Das gesamte Design wird anschließend durch einen Implementierungsprozess in einen Bitstrom übersetzt.

Zwischen den Blockausgängen des Simulink Blockschaltbilds und den FPGA-Komponenten (D-FlipFlops) bzw. den zu den FPGA-Komponenten gehörigen Speicherstellen 9 im Konfigurationsspeicher 8 wird eine Beziehung hergestellt. Diese Abbildung wird sukzessive während des FPGA Builds 22 aufgebaut bzw. verfeinert (refine).

Wird das Blockschaltbild eines FPGA-Subsystems durch den XSG in eine HDL übersetzt, so sind diese beiden Beschreibungen im Bezug auf ihre Struktur ähnlich. Dies lässt sich nutzen, um eine direkte Relation zwischen z.B. einem Blockausgang eines Simulink-Blocks und Ports einer Entity zu erstellen.

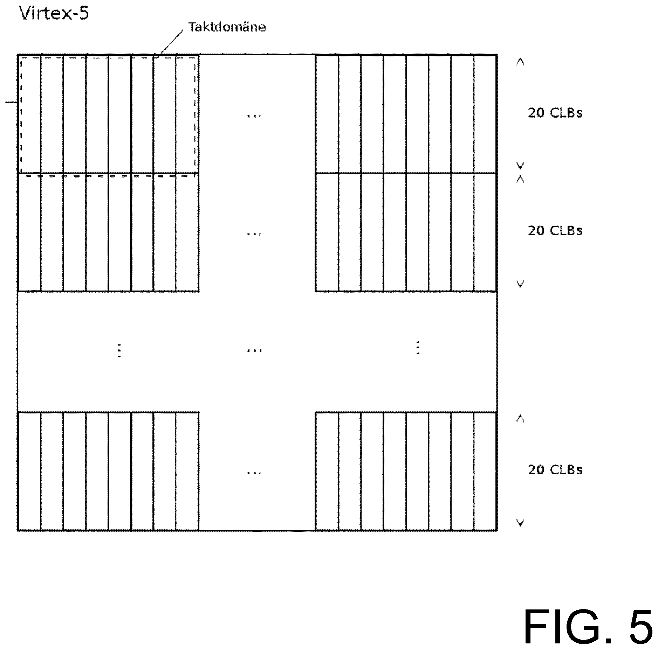

Das Verfahren umfasst zusätzlich das Optimieren der FPGA Hardware-Konfiguration 24 mit der Anordnung von Speicherstellen 9, die Zustandsdaten für einen Signalwert beinhalten, in einer Readback-Spalte des FPGA 5. Die Organisation des Konfigurationsspeichers 8 in Readback-Spalten ist in Fig. 5 gezeigt. Ein Frame umfasst eine 1-Bit breite und 1312-Bit lange Spalte im Konfigurationsspeicher 8 und erstreckt sich über eine CLB-Spalte der funktionalen Ebene 6. Eine Korrelation zwischen einem Bit innerhalb eines Frames und dem funktionalen Element, das es konfiguriert, kann durch die Xilinx Tools ermittelt werden. Zum Bestimmen eines Signalwerts ist somit nur ein Teil eines Frames von Interesse. Durch die Anordnung in einer Readback-Spalte wird der Zugriff auf die Zustandsdaten für einen Signalwert beschleunigt. Bei einer Anordnung aller Speicherstellen 9 für einen Signalwert innerhalb einer Readback-Spalte kann darauf mit einer Operation zugegriffen werden. Es werden Signalwerte, die nicht zur Laufzeit des FPGA 5 verändert werden, separat von FPGA-Konfigurationen, die sich zur Laufzeit ändern können, in Readback-Spalten angeordnet.

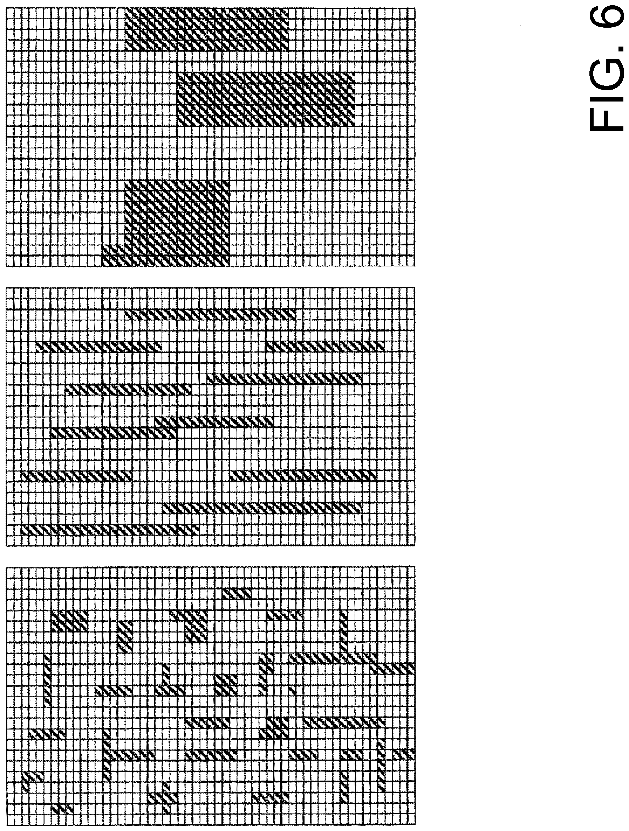

Wie in Fig. 6, linke Abbildung, gezeigt ist, sind relevante Readback-Spalten zunächst über den gesamten Konfigurationsspeicher 8 verteilt. Durch ein Optimieren der FPGA Hardware-Konfiguration 24 werden Speicherstellen 9, die Zustände für einen Signalwert beinhalten, in benachbarten Bereichen des FPGA 5 angeordnet. Benachbarte Bereiche können eine einzelne Readback-Spalte des FPGA 5 betreffen, oder eine Mehrzahl von benachbarten Readback-Spalten. Durch die benachbarte Anordnung wird der Zugriff auf die Speicherstellen 9 beschleunigt. Durch eine Anordnung von Speicherstellen 9 für zwei Signalwerte innerhalb einer Readback-Spalte wird auf beide Signalwerte mit einer Operation zugegriffen. Fig. 6, mittlere Abbildung, zeigt eine Optimierung mit einer Konzentration von relevanten Speicherstellen 9 in einer reduzierten Anzahl von Readback-Spalten. Gemäß Fig. 6, rechte Abbildung, sind in einer weiteren Optimierung die relevanten Readback-Spalten zusätzlich benachbart in dem FPGA 5 angeordnet.

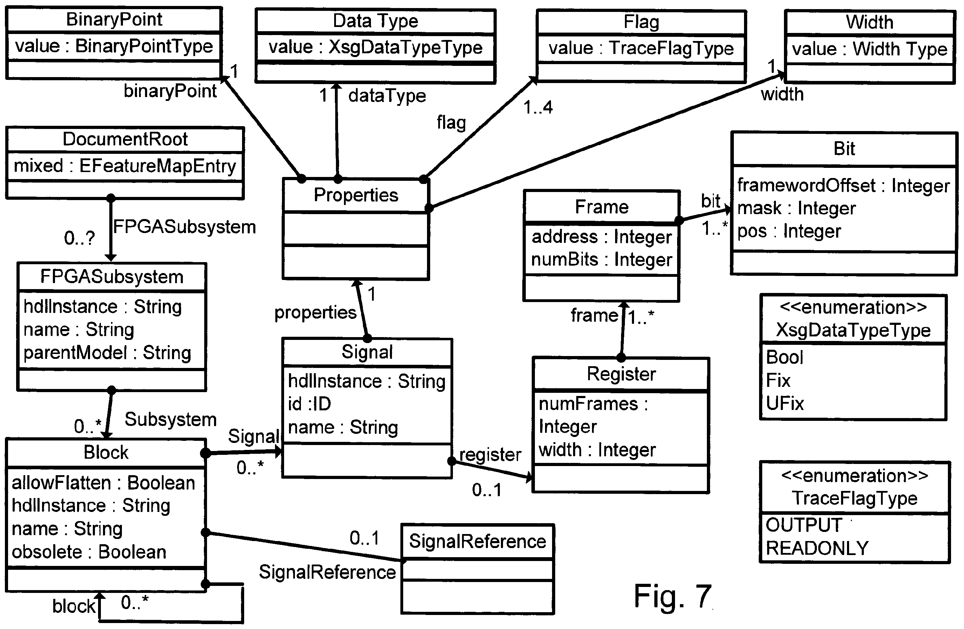

Ein Schema für ein XML-Modell 70, welches die relevanten Informationen der Signale enthält, ist modellhaft in Fig. 7 dargestellt.

Ein Element vom Typ FPGASubsystem bildet die Wurzel jeder Readback-Modell Instanz. Das FPGA-Subsystem enthält in Anlehnung an die Modell-Hierarchie von Simulink rekursiv weitere Subsystem-Instanzen. Ein Subsystem kann in diesem Kontext sowohl als primitiver Block (z.B. Addierer), als auch als Simulink-Subsystem ausgeführt sein. Ein Name eines Subsystems bzw. Blocks und der Name der dazugehörigen HDL-Entity werden in den Eigenschaften name bzw. hdllnstance der Subsystem-Klasse gespeichert.

Jedes Subsystem kann mehrere Signale umfassen, welche Signale bzw. I/O-Ports im Simulink-Modell darstellen. Jedes Signal bekommt über die id-Eigenschaft einen eindeutigen Bezeichner. Da die Richtung der Signale (In/Out) keine Rolle spielt und Redundanzen bei der Modellierung zu vermeiden sind, stellt die Signal-Klasse per Konvention die Ausgänge der Blöcke bzw. Subsysteme im Simulink-Modell dar. Teilen sich mehre Subsysteme die gleichen Signale, kann über eine Instanz der SignalReference-Klasse auf Signale anderer Subsystem-Instanzen referenziert werden.

Ein Signal kann durch die Synthese mit einem Register 60 assoziiert sein. Diese Assoziation findet sich ebenfalls zwischen der Signal- und Register-Klasse wieder. Die Beziehung zwischen einem Register 60 und den Frames, in denen die Initialwerte des Registers 60 gespeichert werden, wird über die entsprechenden Klassen modelliert. Die Eigenschaften eines Signals werden über die Properties-Klasse modelliert. Für das Zurücklesen und das anschließende Aufbereiten der Signale sind vor allem die Eigenschaften BinaryPoint, DataType und Width relevant.

Ein Register Element ist über die Frame-Klasse mit mehreren Bits assoziiert. Das Register 60 verfügt, ebenso wie das Signal, über eine eigene width-Eigenschaft, da die Breite eines Signals und die Breite des dazugehörigen Registers 60 unter Umständen variieren können. Ein Bit gibt über die Bitposition (pos) zunächst an, um welches Bit des Registers 60 es sich handelt. Außerdem enthält eine Bit-Instanz Informationen darüber, in welchem Wort (framewordOffset) innerhalb des Frames sich das Register-Bit befindet und mit welcher Bitmaske (mask) sich der Wert des Bits aus dem Framewort ausmaskieren lässt.

Das Readback-Modell ist in einer XML-Datei gespeichert. So kann das Modell beispielsweise toolübergreifend bearbeitet werden. Das Modell wird durch die Validierung gegen ein XSD-Schema syntaktisch und strukturell korrekt gehalten.

Das Verfahren umfasst den zusätzlichen Schritt des Erzeugens eines FPGA-Codes 44 als Readback Applikation zum Bestimmen eines Signalwertes, wobei der FPGA-Code 44 das Auslesen der Zustandsdaten aus dem Konfigurationsspeicher 8 als Rücklesedaten und das Bestimmen des Signalwertes aus den Rücklesedaten basierend auf der dem FPGA Variable Mapping File 13 umfasst.

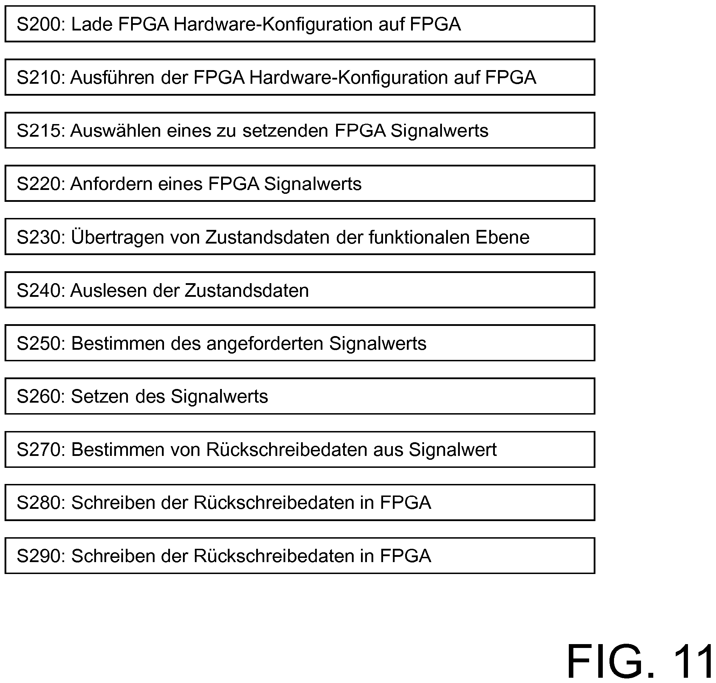

Das Verfahren umfasst den zusätzlichen Schritt des Erzeugens eines FPGA-Codes 44 als Writeback Applikation zum Verändern eines Signalwertes, wobei der FPGA-Code 44 das Bestimmen der Rückschreibedaten aus dem Signalwert und das Schreiben der Rückschreibedaten als Zustandsdaten in den Konfigurationsspeicher 8 des FPGA 5 basierend auf der dem FPGA Variable Mapping File 13 umfasst. Details sind nachstehend unter Bezug auf insbesondere Fig. 11 beschrieben.

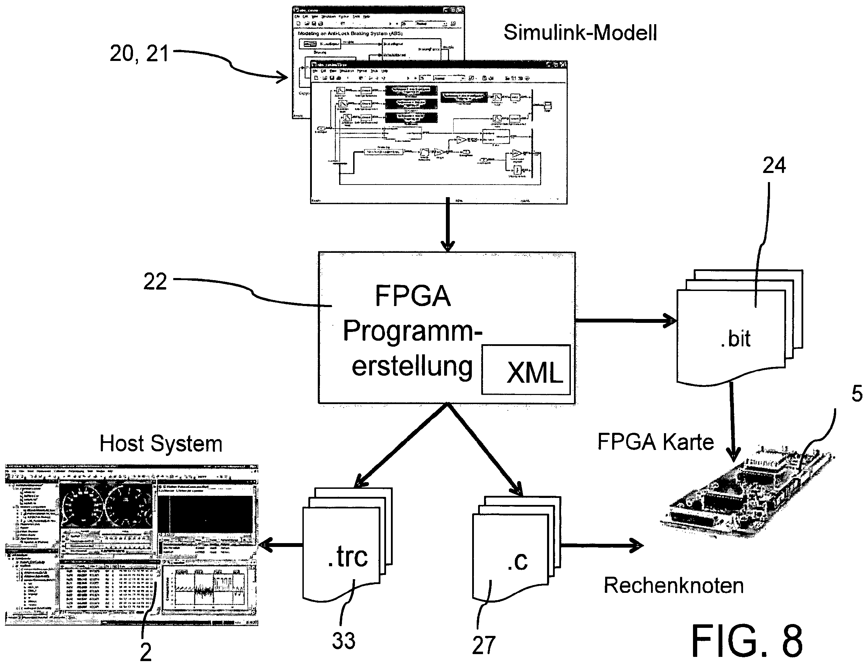

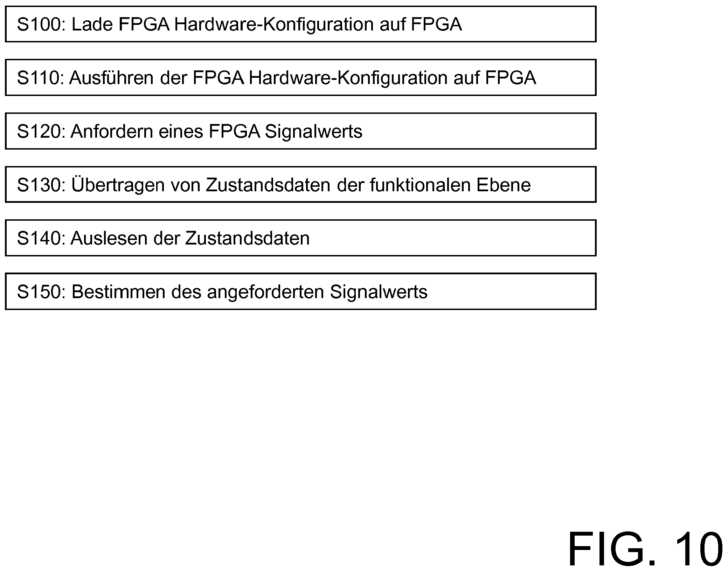

Fig. 8 zeigt die Verteilung der Ergebnisse des Build Verfahrens auf die verschiedenen Komponenten. Aus dem Simulink Modell 20, 21 wird ein Build mit einem FPGA Build 22 durchgeführt. Es wird eine FPGA Hardware-Konfiguration 24 erzeugt und auf das FPGA 5 geladen. Dies entspricht in dem unter Bezug auf Fig. 10 beschriebenen Verfahren dem Schritt S100. Die Applikation 27 wird auf den Rechenknoten 4 geladen, und das vollständige Tracefile 33 wird an den Steuerungsrechner 2 übertragen.

Im Betrieb werden die FPGA Hardware Konfiguration 24 auf dem FPGA 5 gestartet und ausgeführt. Dies entspricht in dem unter Bezug auf Fig. 10 beschriebenen Verfahren dem Schritt S110. Die Applikation 27 wird auf dem Rechenknoten 4 gestartet und ausgeführt. Auf dem Steuerungsrechner 2 wird eine Steuerungssoftware 50 gestartet, die in diesem Ausführungsbeispiel eine dSPACE ControlDesk Software ist. Das ControlDesk 50 kommuniziert mit dem Echtzeitsystem 3 über den Rechenknoten 4, wie in Fig. 1 gezeigt ist.

Zur Anzeige eines Signalwertes des FPGA 5 während der Laufzeit kann dieser über das ControlDesk 50 angefordert werden. Dies entspricht in dem unter Bezug auf Fig. 10 beschriebenen Verfahren dem Schritt S120. Der Zugriff auf verschiedene Signalwerte erfolgt über das vollständige Trace File 33 und eine grafische Modellierung mit Simulink. Die Darstellung des Signalwerts erfolgt als graphische Darstellung, wobei der Signalwert aus einer Liste per "Drag and Drop" auf dargestellte Instrumente zur Anzeige von Signalwerten gezogen wird. Der Signalwert aus der Liste wird anhand einer eindeutigen Identifikationsnummer identifiziert.

Der Signalwert wird von dem ControlDesk 50 von dem Rechenknoten 4 angefordert. Dazu ist auf dem Rechenknoten 4 ein Data Acquisition Service 51 implementiert, der die Anforderung von dem ControlDesk 50 empfängt. Von dem Data Acquisition Service 51 wird der Signalwert von dem Controller 12 für den FPGA 5 angefordert. Dieser initiiert während des Betriebs des FPGA 5 das Übertragen von Zustandsdaten aus der funktionalen Ebene 6 des FPGA 5 in seinen Konfigurationsspeicher 8. Dieser Schritt entspricht in dem unter Bezug auf Fig. 10 beschriebenen Verfahren dem Schritt S130. Während des Betriebs werden so durch einen Trigger alle Registerinhalte der funktionalen Ebene 6 in die Konfigurationsebene 7 gespiegelt. In einer alternativen Ausführungsform werden aus dem FPGA Variable Mapping File 13 für das Bestimmen des Signalwerts erforderliche Teile der Zustandsdaten ermittelt und nur diese Teile in den Konfigurationsspeicher 8 gesichert.

Weiter werden in dem FPGA 5 von der Readback Applikation 44 Zustandsdaten aus dem Konfigurationsspeicher 8 als Rücklesedaten ausgelesen. Dies entspricht in dem unter Bezug auf Fig. 10 beschriebenen Verfahren dem Schritt S140. Die ausgelesenen Rücklesedaten umfassen hier einen oder mehrere Frames, d.h. eine oder mehrere Readback-Spalten des FPGA 5. Dabei werden zunächst Readback-Spalten, die für das Bestimmen des Signalwerts erforderlich sind, ermittelt, und nur diese Readback-Spalten ausgelesen. Diese Informationen über die erforderlichen Readback-Spalten sind über das FPGA Variable Mapping File 13 zu ermitteln.

Basierend auf den Rücklesedaten wird in dem FPGA 5 der Signalwert bestimmt. Dies entspricht in dem unter Bezug auf Fig. 10 beschriebenen Verfahren dem Schritt S150. Dazu werden Registerwerte aus den Frames gesucht und extrahiert. Die Informationen ergeben sich aus dem FPGA Variable Mapping File 13. Es erfolgt das Abbilden der Rücklesedaten auf wenigstens einen Registerwert. Dabei wird der Signalwert aus Zustandsdaten mehrerer Register 60 gebildet soweit erforderlich. Entsprechend werden die Inhalte der Register 60 gemäß des FPGA Variable Mapping Files 13 gemeinsam verarbeitet, um den Signalwert zu bestimmen.

Der so bestimmte Signalwert wird über die Schnittstelle 11 des FPGA 5 an den Controller 12 übertragen, der den Signalwert über den Data Acquisition Service 51 des Rechenknotens 4 an das ControlDesk 50 des Steuerungsrechners 2 überträgt.

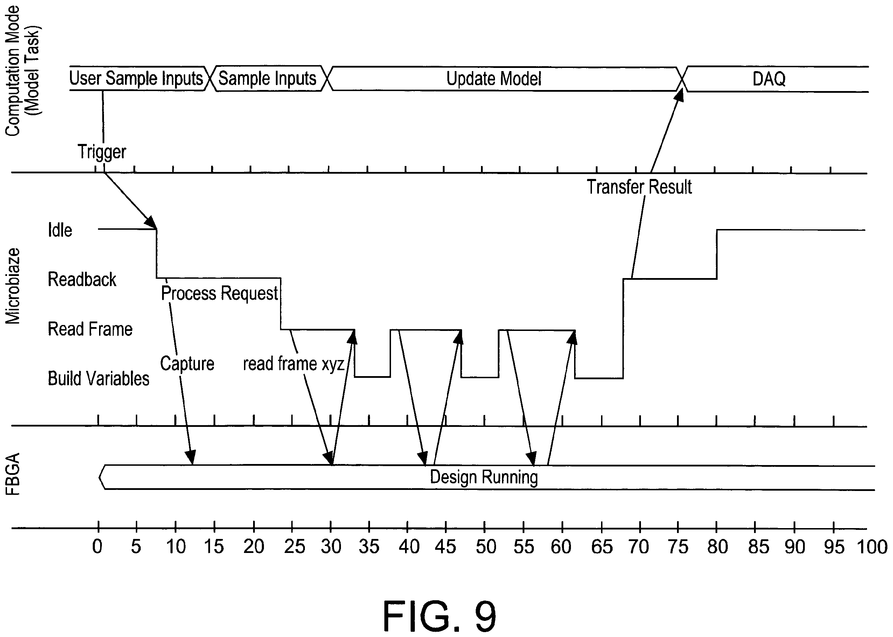

Ein Zeitdiagramm zum Übertragen von Zustandsdaten aus der funktionalen Ebene des FPGA an einen anfragenden Rechner ist Fig. 9 gezeigt.

In Analogie zu dem vorhergehend beschriebenen lesenden Zugriff auf einen Signalwert des FPGA 5 ist auch ein schreibender Zugriff zum Verändern eines Signalwerts des FPGA 5 möglich, der im Folgenden unter Bezug auf die Fig. 11 beschrieben wird.

Das Verfahren zum Verändern eines Signalwerts des FPGA 5 beginnt in Schritt S200 mit dem Laden einer FPGA Hardware-Konfiguration 24 auf das FPGA 5. Schritt S200 entspricht dem zuvor beschriebenen Schritt S100.

In Übereinstimmung mit dem zuvor beschrieben Schritt S110 wir in Schritt S210 die FPGA Hardware Konfiguration 24 auf dem FPGA 5 gestartet und ausgeführt.

In Schritt S215 wird ein zu setzende FPGA Signalwert ausgewählt. Als Grundlage für das Verändern des FPGA Signalwerts wird in den Schritten S220 bis S250 in Übereinstimmung mit den zuvor beschriebenen entsprechenden Schritten S120 bis S150 ein Signalwert aus der funktionalen Ebene 6 des FPGA 5 ausgelesen.

In Schritt S260 wird der Signalwert gesetzt. Dazu wird einem Nutzer zunächst der ausgelesene Signalwert angezeigt, woraufhin dieser einen neuen Wert für den Signalwert setzt.

In Schritt S270 werden aus dem Signalwert Rückschreibedaten bestimmt. Die Bestimmung der Rückschreibedaten erfolgt basierend auf den Prinzipien der zuvor unter Bezug auf Schritt S150 beschriebenen Bestimmung des Signalwerts aus den Rücklesedaten. Entsprechend wird der Signalwert auf die Rückschreibedaten für ein oder mehrere Register 60 abgebildet. In den zuvor in Schritt S230 übertragenen Zustandsdaten werden die durch die Änderung des Signalwerts resultierenden Änderungen durchgeführt.

In Schritt S280 werden die Rückschreibedaten als Zustandsdaten in den Konfigurationsspeicher 8 des FPGA geschrieben. Das Schreiben der Rückschreibedaten in den Konfigurationsspeicher 8 erfolgt basierend auf den Prinzipien des zuvor unter Bezug auf Schritt S140 beschriebenen Auslesens der Zustandsdaten. Entsprechend werden alle Zustandsdaten des Bereichs, der die Konfiguration des Signalwerts in der funktionalen Ebene 6 enthält, dorthin gespiegelt.

In Schritt S290 werden die Rückschreibedaten aus dem Konfigurationsspeicher 8 in die funktionale Ebene 6 des FPGA 5 übertragen. Das Übertragen der Rückschreibedaten in den Konfigurationsspeicher 8 erfolgt basierend auf den Prinzipien des zuvor unter Bezug auf Schritt S130 beschriebenen Übertragens von Zustandsdaten der funktionalen Ebene 6.

Nachfolgend werden verschiedene Implementierungen von Signalwerten unter Bezug auf die Figuren 12 bis 15 beschrieben.

In Fig. 12 ist die Implementierung eines Signalwerts durch Register 60 gemäß der bevorzugten Ausführungsform dargestellt. Dabei wird jedes einzelne Bit des Signalwerts durch ein Register 60 abgebildet. Die Register 60 dienen als Entität zum Bestimmen der relevanten Bereiche im Konfigurationsstrom des FPGA (Bitstream), die zur Laufzeit entsprechend der gewünschten Signalwerte verändert werden müssen. Somit müssen die Register 60 keine Eingänge aufweisen. Auch eine Verbindung mit der Systemclock kann optional implementiert sein. Bei der Implementierung muss dafür gesorgt werden, dass der jeweilige Signalwert in Form eines Registers 60 implementiert wird. Alternativ kann in der Hardwarebeschreibung, d.h. der VHDL-Beschreibung, des Designs der Signalwert durch die entsprechenden Register-Makros ersetzt werden. Nach der Implementierung des initialen FPGA Designs kann anhand des Report Files, d.h. des Logic Allocation File 23, die genaue Adresse eines jeden Register Bits aller Signalwerte im FPGA Bitstrom bestimmt werden. Nach dem Laden und Betreiben des initialen Datenstroms kann während der Laufzeit ein Signalwert verändert werden, in dem die jeweiligen Werte des Registers 60 per partieller Rekonfiguration verändert werden. Anschließend wird ein Reset-Signal gesetzt, so dass für alle veränderten Register 60 der neue Wert des Signalwerts aktiv wird.

Der Ressourcenbedarf beschränkt sich bei der Verwendung von Registern 60 auf je ein Register 60 pro Bit des zu verstellenden Signalwerts. Die Register 60, die zur Repräsentation des Signalwerts benötigt werden, stehen dem Anwender nicht mehr zur Verfügung. Durch die Verwendung von dedizierten globalen Reset Netzen im FPGA 5 beeinflusst das zusätzliche Reset Netz die Routing Möglichkeiten des restlichen FPGA Designs nur unwesentlich. Die Bestimmung von Teilen des Konfigurationsdatenstroms des FPGAs 5, die manipuliert werden müssen, um einen Signalwert zu verändern, können leicht bestimmt werden.

In Fig. 13 ist die Implementierung eines Signalwerts durch die Repräsentation der einzelnen Bits durch Ausgänge einer Look-Up Table 61 (LUT) dargestellt gemäß einer alternativen Ausführungsform. Jede FPGA Verarbeitungseinheit (CLB) umfasst mehrere Look-Up Tables 61, die normalerweise dazu verwendet werden, beliebige Logikfunktionen zu realisieren. Hier werden die Look-Up Tables 61 als Quelle der Signalwerte verwendet, deren Logikfunktion zur Laufzeit durch partielle Rekonfiguration verändert werden kann.

Bei der Implementierung muss in der VHDL-Beschreibung dafür gesorgt werden, dass für die Signalwerte jeweils entsprechend viele LUT-Makros instanziiert werden. Nach dem FPGA Implementierungsprozess muss bestimmt werden, welcher Teil des Konfigurationsdatenstroms manipuliert werden muss, um den Inhalt der Look-Up Tables 61 zu manipulieren. Während der Laufzeit wird dann entsprechend der Signalwert verändert, indem entsprechende Bereiche im Konfigurationsdatenstrom des FPGAs 5 ermittelt und durch partielle Rekonfiguration verändert werden.

In Fig. 14 ist die Implementierung eines Signalwerts gemäß einer weiteren alternativen Ausführungsform durch den Multiplexer 62 dargestellt. Ein Bit des Signalwerts ist als Ausgang des Multiplexers 62 realisiert. Die beiden Eingänge des Multiplexers 62 sind mit 0 (S1) und 1 (S2) verbunden. Ein Selektor (C) des Multiplexers 62 wird über ein Bit der FPGA Konfiguration gesteuert, um zwischen den Eingängen des Multiplexers 62 umzuschalten. Bei der Implementierung muss sichergestellt werden, dass der Signalwert in Form eines Mulitiplexers 62 implementiert wird und es muss nach der Implementierung bekannt sein, an welcher Stelle im Konfigurationsstrom der Multiplexer 62 wieder gefunden werden kann. Während der Laufzeit wird dann entsprechend der Signalwert verändert, indem der entsprechende Bereich im Konfigurationsdatenstrom des FPGAs 5 ermittelt und durch partielle Rekonfiguration verändert wird.

Gegenüber der Repräsentation des Signalwerts durch Register 60 oder Look-up Tables 61 werden bei der Implementierung eines Signalwerts mit Multiplexer 62 wenige Logikressourcen verwendet.

In Fig. 15 ist die Implementierung eines Signalwerts gemäß einer noch weiteren Ausführungsform durch Routing zu VCC/GND dargestellt. Dies ist eine besonders ressourcenschonende Möglichkeit der Implementierung eines Signalwerts. In der Switch-Box 63 ist jedes Bit des Signalwerts auf einen 0 oder 1 Konnektor gedrahtet, sofern nicht auf die Implementierung in Form von Constraints Einfluss genommen wird. Das Routing der einzelnen Bits des Signalwerts kann während der Laufzeit durch partielle Rekonfiguration innerhalb der Switch-Box 63 so verändert werden, dass aus einer ursprünglichen 1, die durch eine durchgezogene Linie dargestellt ist, eine 0, die durch eine gestrichelte Linie dargestellt ist, wird oder umgekehrt.

Während des Betriebs können durch partielles Rekonfigurieren des FPGAs 5 die jeweils relevanten Anteile im FPGA 5 überschrieben werden. Der Signalwert, hier ein Simulink Konstant Block, wird auf die rekonfigurierbare Look-up Table 61, ein Register 60 oder einen Multiplexer 62 abgebildet. Anschließend wird der Signalwert mittels partieller, dynamischer Rekonfiguration auf einen beliebigen Wert verändert.

Das Verfahren ist als Computerprogrammprodukt mit Computer-implementierten Anweisungen implementiert, das nach dem Laden und Ausführen in dem Echtzeitsystem 3 die Schritte des obigen Verfahrens ausführt.

Ein digitales Speichermedium stellt elektronisch auslesbare Steuersignale bereit, die so mit dem Echtzeitsystem 3 zusammenwirken, dass das obige Verfahren auf dem Echtzeitsystem 3 ausgeführt wird.

**Bezugszeichenliste**

| | |
|---|---|
| Datenverarbeitungssystem | 1 |
| Steuerungsrechner | 2 |
| Echtzeitsystem, Datenverarbeitungseinrichtung | 3 |
| Rechenknoten | 4 |
| FPGA | 5 |
| funktionale Ebene | 6 |
| Konfigurationsebene | 7 |
| Konfigurationsspeicher | 8 |
| Speicherstellen | 9 |
| FPGA-Board | 10 |
| Schnittstelle | 11 |
| Controller | 12 |
| FPGA Variable Mapping File | 13 |
| FPGA Modell | 20 |
| CPU-Modell | 21 |
| FPGA Build | 22 |
| Logic Allocation File | 23 |
| FPGA Hardware-Konfiguration | 24 |
| CPU Build | 26 |
| Applikation | 27 |
| CPU Trace File Generator | 28 |
| CPU Trace File | 29 |
| FPGA Trace File Generator | 30 |
| FPGA Trace File | 31 |
| Trace File Merger | 32 |
| vollständiges Trace File | 33 |
| Blockschaltbild | 40 |
| Model.ini-Datei | 41 |
| Xilinx System Generator | 42 |
| Readback File Generation | 43 |
| FPGA-Code, Readback Applikation | 44 |
| Readback Application Source | 45 |
| Steuerungssoftware, ControlDesk | 50 |
| Data Acquisition Service | 51 |
| Register | 60 |
| Look-up Table | 61 |
| Multiplexer | 62 |
| Switch-Box | 63 |
| Signale XML Model | 70 |
| Map File Generator | 71 |

## Patentansprüche

1. Verfahren zum Verändern eines Signalwerts eines FPGA (5) zur Laufzeit, umfassend die Schritte
Laden (S200) einer FPGA Hardware Konfiguration (24) mit wenigstens einem Signalwert auf den FPGA (5),
Ausführen (S210) der FPGA Hardware Konfiguration (24) auf dem FPGA (5),
Setzen (S260) des Signalwertes zur Übertragung an das FPGA (5),
Bestimmen (S270) von Rückschreibedaten aus dem Signalwert,
Schreiben (S280) der Rückschreibedaten als Zustandsdaten in einen Konfigurationsspeicher (8) des FPGA (5), und
Übertragen (S290) der Zustandsdaten aus dem Konfigurationsspeicher (8) in die funktionale Ebene (6) des FPGA (5), **dadurch gekennzeichnet, dass**
Signalwerte, die verändert werden können gemeinsam angeordnet werden, separat von Elementen des FPGA in der funktionalen Ebene, deren Konfiguration sich zur Laufzeit ändern kann, und dass das Verändern des Signalwerts erfolgt, während der FPGA (5) ununterbrochen weiterläuft.

2. Verfahren nach Anspruch 1, **dadurch gekennzeichnet, dass** das Verfahren vor dem Übertragen der Zustandsdaten aus dem Konfigurationsspeicher (8) in die funktionale Ebene (6) des FPGA (5) den zusätzlichen Schritt umfasst
Übertragen von Zustandsdaten aus der funktionalen Ebene (6) des FPGA (5) in den Konfigurationsspeicher (8) in dessen Konfigurationsebene (7).

3. Verfahren nach einem der vorhergehenden Ansprüche 1 oder 2, **dadurch gekennzeichnet, dass**
der Schritt des Bestimmens der Rückschreibedaten aus dem Signalwert das Abbilden des Signalwerts auf die Rückschreibedaten umfasst.

4. Verfahren nach einem der vorhergehenden Ansprüche, **dadurch gekennzeichnet, dass**
der Schritt des Schreibens der Rückschreibedaten als Zustandsdaten in einen Konfigurationsspeicher (8) des FPGA (5) das Ermitteln von für das Verändern des Signalwerts erforderlichen Bereichen des Konfigurationsspeichers (8) und das Schreiben von Zustandsdaten der erforderlichen Bereiche des Konfigurationsspeichers (8) als Rückschreibedaten umfasst.

5. Verfahren nach einem der vorhergehenden Ansprüche, **dadurch gekennzeichnet, dass**
der Schritt des Übertragens der Zustandsdaten aus dem Konfigurationsspeicher (8) in die funktionale Ebene (6) des FPGA (5) das Ermitteln von für das Schreiben der Zustandsdaten erforderlichen Teilen der funktionalen Ebene (6) des FPGA (5) und das Übertragen dieser Teile der Zustandsdaten in die funktionale Ebene (6) umfasst.

6. Verfahren nach einem der vorhergehenden Ansprüche, **dadurch gekennzeichnet, dass**
das Ermitteln von für das Verändern des Signalwerts erforderlichen Bereichen des Konfigurationsspeichers (8) und/oder das Ermitteln von für das Schreiben der Zustandsdaten erforderlichen Teilen der funktionalen Ebene (6) des FPGA (5) das identifizieren der jeweiligen Bereiche über eine Identifikationsnummer umfasst.

7. Verfahren nach einem der vorhergehenden Ansprüche, **dadurch gekennzeichnet, dass**
der Schritt des Setzens des Signalwertes zur Übertragung an das FPGA (5) das Bereitstellen einer Liste verfügbarer Signalwerte und die Auswahl eines Signalwerts aus dieser Liste umfasst.

8. Verfahren nach einem der vorhergehenden Ansprüche, **dadurch gekennzeichnet, dass**
der Schritt des Ausführens der FPGA Hardware Konfiguration (24) auf dem FPGA (5) das Ausführen der Hardware Konfiguration (24) als Echtzeitanwendung umfasst, und das Verfahren zum Verändern eines Signalwerts eines FPGA (5) zur Laufzeit der Echtzeitanwendung durchgeführt wird.

9. Verfahren nach einem der vorhergehenden Ansprüche, **dadurch gekennzeichnet, dass**
der Schritt des Übertragens der Zustandsdaten aus dem Konfigurationsspeicher (8) in die funktionale Ebene (6) des FPGA (5) das Senden eines Reset-Signals an das FPGA (5) umfasst.

10. Verfahren nach Anspruch 9, **dadurch gekennzeichnet, dass** der Schritt des Sendens eines Reset-Signals an das FPGA (5) das Senden eines Reset-Signals zum partiellen Übertragen der Zustandsdaten aus dem Konfigurationsspeicher (8) in die funktionale Ebene (6) des FPGA (5) umfasst.

11. Datenverarbeitungseinrichtung (3) mit einer Prozessoreinheit
und einem FPGA, wobei
die Datenverarbeitungseinrichtung (3) zur Durchführung des Verfahrens nach einem der Ansprüche 1 bis 10 ausgeführt ist.

12. Computerprogrammprodukt mit Computer-implementierten
Anweisungen, das nach dem Laden und Ausführen in einer geeigneten Datenverarbeitungseinrichtung (3) nach Anspruch 11 die Schritte des Verfahrens nach einem der Ansprüche 1 bis 10 ausführt.

13. Digitales Speichermedium mit elektronisch auslesbaren Steuersignalen, die so mit einer programmierbaren Datenverarbeitungseinrichtung (3) nach Anspruch 11 zusammenwirken können, dass das Verfahren nach einem der Ansprüche 1 bis 10 auf der Datenverarbeitungseinrichtung (3) ausgeführt wird.

## Claims

1. A method for modifying a signal value of an FPGA (5) during runtime, comprising the steps
loading (S200) an FPGA hardware configuration (24) having at least one signal value onto the FPGA (5),
executing (S210) the FPGA hardware configuration (24) on the FPGA (5),
setting (S260) the signal value for transferring to the FPGA (5),
determining (S270) reply data from the signal value,
writing (S280) the reply data as state data in a configuration memory (8) of the FPGA (5), and
transferring (S290) the state data from the configuration memory (8) into the functional level (6) of the FPGA (5), **characterized in that**
signal values able to be modified are disposed together, separately from
elements of the FPGA in the functional level, the configuration of which can change during runtime, and that the modifying of the signal value takes place while the FPGA (5) continues to run uninterrupted.

2. The method according to claim 1, **characterized in that**
prior to transferring the state data from the configuration memory (8) into the functional level (6) of the FPGA (5), the method comprises the additional step of
transferring state data from the functional level (6) of the FPGA (5) into the configuration memory (8) in the configuration level (7) thereof.

3. The method according to any one of the preceding claims 1 or 2, **characterized in that** the step of determining the reply data from the signal value comprises mapping the signal value to the reply data.

4. The method according to any one of the preceding claims, **characterized in that**
the step of writing the reply data as state data into a configuration memory (8) of the FPGA (5) comprises determining ranges of the configuration memory (8) necessary for modifying the signal value and writing state data of the necessary ranges of the configuration memory (8) as reply data.

5. The method according to any one of the preceding claims, **characterized in that**
the step of transferring the state data from the configuration memory (8) into the functional level (6) of the FPGA (5) comprises determining parts of the functional level (6) of the FPGA (5) necessary for writing the state data and transferring said parts of the state data into the functional level (6).

6. The method according to any one of the preceding claims, **characterized in that**
determining ranges of the configuration memory (8) necessary for modifying the signal value and/or determining parts of the functional level (6) of the FPGA (5) necessary for writing the state data comprises identifying each of the ranges by means of an identification number.

7. The method according to any one of the preceding claims, **characterized in that**
the step of setting the signal value for transferring to the FPGA (5) comprises providing a list of available signal values and selecting a signal value from said list.

8. The method according to any one of the preceding claims, **characterized in that**
the step of executing the FPGA hardware configuration (24) on the FPGA (5) comprises executing the hardware configuration (24) as a real-time application, and the method for modifying a signal value of an FPGA (5) is performed during runtime of the real-time application.

9. The method according to any one of the preceding claims, **characterized in that**
the step of transferring the state data from the configuration memory (8) into the functional level (6) of the FPGA (5) comprises transmitting a reset signal to the FPGA (5).

10. The method according to claim 9, **characterized in that**
the step of transmitting a reset signal to the FPGA (5) comprises transmitting a reset signal for partially transferring the state data from the configuration memory (8) into the functional level (6) of the FPGA (5).

11. A data processing device (3) having a processor unit and an FPGA, **characterized in that**
the data processing device (3) is implemented for performing the method according to any one of the claims 1 through 10.

12. A computer program product having computer implemented instructions for performing the steps of the method according to any one of the claims 1 through 10 after being loaded and executed in a suitable data processing device (3) according to claim 11.

13. A digital storage medium having electronically readable control signals able to interact with a programmable data processing device (3) according to claim 11 such that the method according to any one of the claims 1 through 10 is performed on the data processing device (3).

## Revendications

1. Procédé pour modifier une valeur de signal d'un FPGA (5) pendant la durée d'exécution, comprenant les étapes consistant à
charger (S200) une configuration (24) de matériel FPGA avec au moins une valeur de signal dans le FPGA (5),
exécuter (S210) la configuration (24) de matériel FPGA sur le FPGA (5),
définir (S260) la valeur de signal en vue de la transmission au FPGA (5),
déterminer (S270) des données de réécriture à partir de la valeur de signal,
écrire (S280) les données de réécriture en tant que données d'état dans une mémoire de configuration (8) du FPGA (5), et
transmettre (S290) les données d'état depuis la mémoire de configuration (8) dans le niveau fonctionnel (6) du FPGA (5), **caractérisé en ce que**
les valeurs de signal qui peuvent être modifiées sont disposées ensemble, séparément des éléments du FPGA dans le niveau fonctionnel, dont la configuration peut changer pendant la durée d'exécution,
et **en ce que** la modification de la valeur de signal a lieu pendant que le FPGA (5) continue à fonctionner sans interruption.

2. Procédé selon la revendication 1, **caractérisé en ce que** le procédé comprend, avant la transmission des données d'état depuis la mémoire de configuration (8) dans le niveau fonctionnel (6) du FPGA (5), l'étape supplémentaire consistant à
transmettre des données d'état depuis le niveau fonctionnel (6) du FPGA (5) dans la mémoire de configuration (8), dans son niveau de configuration (7).

3. Procédé selon l'une quelconque des revendications 1 ou 2 précédentes, **caractérisé en ce que**
l'étape consistant à déterminer les données de réécriture à partir de la valeur de signal comprend la représentation de la valeur de signal avec les données de réécriture.

4. Procédé selon l'une quelconque des revendications précédentes, **caractérisé en ce que**
l'étape consistant à écrire les données de réécriture en tant que données d'état dans une mémoire de configuration (8) du FPGA (5) comprend la détermination de zones de la mémoire de configuration (8) nécessaires pour la modification de la valeur de signal et l'écriture de données d'état des zones nécessaires de la mémoire de configuration (8) en tant que données de réécriture.

5. Procédé selon l'une quelconque des revendications précédentes, **caractérisé en ce que**
l'étape consistant à transmettre les données d'état depuis la mémoire de configuration (8) dans le niveau fonctionnel (6) du FPGA (5) comprend la détermination de parties du niveau fonctionnel (6) du FPGA (5) nécessaires pour l'écriture des données d'état et la transmission de ces parties des données d'état dans le niveau fonctionnel (6).

6. Procédé selon l'une quelconque des revendications précédentes, **caractérisé en ce que**
la détermination de zones de la mémoire de configuration (8) nécessaires pour la modification de la valeur de signal et/ou la détermination de parties du niveau fonctionnel (6) du FPGA (5) nécessaires pour l'écriture des données d'état comprend l'identification des zones respectives par le biais d'un numéro d'identification.

7. Procédé selon l'une quelconque des revendications précédentes, **caractérisé en ce que**
l'étape consistant à définir la valeur de signal en vue de la transmission au FPGA (5) comprend la mise à disposition d'une liste de valeurs de signal disponibles et la sélection d'une valeur de signal dans cette liste.

8. Procédé selon l'une quelconque des revendications précédentes, **caractérisé en ce que**
l'étape consistant à exécuter la configuration (24) de matériel FPGA sur le FPGA (5) comprend l'exécution de la configuration (24) de matériel en tant qu'application en temps réel, et le procédé pour modifier une valeur de signal d'un FPGA (5) est exécuté pendant la durée d'exécution de l'application en temps réel.

9. Procédé selon l'une quelconque des revendications précédentes, **caractérisé en ce que**
l'étape consistant à transmettre les données d'état depuis la mémoire de configuration (8) dans le niveau fonctionnel (6) du FPGA (5) comprend l'émission d'un signal de remise à zéro au FPGA (5).

10. Procédé selon la revendication 9, **caractérisé en ce que** l'étape consistant à émettre un signal de remise à zéro au FPGA (5) comprend l'émission d'un signal de remise à zéro en vue de la transmission partielle des données d'état depuis la mémoire de configuration (8) dans le niveau fonctionnel (6) du FPGA (5).

11. Dispositif (3) de traitement de données avec une unité de processeur et un FPGA, dans lequel
le dispositif (3) de traitement de données est réalisé pour exécuter le procédé selon l'une quelconque des revendications 1 à 10.

12. Produit de programme informatique avec des instructions implémentées sur ordinateur, qui, après le chargement et le lancement dans un dispositif (3) de traitement de données approprié selon la revendication 11, exécute les étapes du procédé selon l'une quelconque des revendications 1 à 10.

13. Support de stockage numérique avec des signaux de commande lisibles électroniquement, qui peuvent coopérer avec un dispositif (3) de traitement de données programmable selon la revendication 11 de sorte que le procédé selon l'une quelconque des revendications 1 à 10 soit exécuté sur le dispositif (3) de traitement de données.
